# EUROPEAN PATENT APPLICATION

(11) **EP 4 793 782 A1**
(43) Date of publication of application: **19.08.2026**
(21) Application number: 26157676.3
(22) Date of filing: 10.02.2026
(51) Int. Cl.: G06F 13/16, G06F 3/06, G11C 7/10, G11C 16/10, G11C 16/26, G06F 13/42, G11C 16/04

(54) **NON-VOLATILE MEMORY DEVICE HAVING HIGH I/O EFFICIENCY BASED ON SEPARATE COMMAND ADDRESS PROTOCOL, OPERATION METHOD THEREOF, AND STORAGE DEVICE INCLUDING SAME**

(30) Priority: 18.02.2025 KR 20250021042; 10.07.2025 KR 20250093326
(71) Applicant: Samsung Electronics Co., Ltd., Suwon-si, Gyeonggi-do 16677 (KR)
(72) Inventor: PARK, Se Hwan, 16677 Suwon-si (KR); JO, Youngmin, 16677 Suwon-si (KR); PARK, Taehyeon, 16677 Suwon-si (KR); KIM, Sang-Lok, 16677 Suwon-si (KR); YOON, Chiweon, 16677 Suwon-si (KR)
(74) Representative: Marks & Clerk LLP

(57) **Abstract**

A storage device includes a memory device including command and address pins, data pins, first control signal pin, memory blocks, and a transceiver transmitting or receiving data through the data pins and a memory controller transmitting a command and an address to the memory device through the command and address pins, transmitting and receiving data to and from the memory device through the data pins, and transmitting a first control signal to the memory device through the first control signal pin. The memory device transmits, in response to receiving a select chip enable packet received through the command and address pins, a second control signal in an activated state to at least one driving circuit that, in response to receiving the second control signal in an activated state, drives the transceiver transmitting and receiving data. The memory device then transmits or receives first data based on the select chip enable packet and the first control signal through the data pins.

## Description

### BACKGROUND

The present disclosure described herein relate to a semiconductor memory device, and more particularly, relate to a non-volatile memory device that communicates with a host based on a separate command address (SCA) protocol and may improve data input/output efficiency, an operation method of the memory device, and a storage device including the memory device.

As technology advances, the demand for increased data input/output (I/O) speed in flash memory devices, which are non-volatile memories, is growing. In particular, with the conventional interfacing method of storage devices, in which commands, addresses, and data are input through input/output (I/O) pins (i.e., through the same I/O pin for commands and addresses), it is difficult to sufficiently meet such high-speed requirements. Therefore, methods that separate command/address pins from data pins are being applied to storage devices including non-volatile memory devices.

Despite changes in the interfacing method, when the overhead in data input/output operations of non-volatile memory devices is not reduced, the efficiency of actual data input/output is not significantly improved.

### SUMMARY

Embodiments of the disclosure provide a non-volatile memory device that uses a communication interface based on a separate command address protocol and may have improved data input/output efficiency, an operation method of the memory device, and a storage device including the memory device.

Further, embodiments of the disclosure provide a non-volatile memory device that uses a communication interface based on a separate command address protocol and may have reduced overhead in data input/output, an operation method of the memory device, and a storage device including the memory device.

According to an aspect of the disclosure, a storage device includes a memory device including a first channel, a second channel, and a third channel, each of the first, second, and third channels comprising at least one pin, a plurality of memory blocks, and a transceiver configured to transmit and receive data through the second channel and a memory controller configured to transmit a command and an address to the memory device through the first channel, transmit and receive data to and from the memory device through the second channel, and transmit a first control signal to the memory device through the third channel. The memory device is configured to transmit a second control signal in an activated state to at least one driving circuit configured to drive the transceiver in response to receiving a select chip enable packet through the first channel, and configured to transmit or receive first data through the second channel based on the select chip enable packet and the first control signal. The memory device may be configured to transmit or receive first data through the second channel based on receipt of the select chip enable packet, and the first control signal being in an activated state.

According to an embodiment, a non-volatile memory device includes a plurality of memory blocks including memory cells, a page buffer circuit configured to store data sensed from the memory cells, a control logic circuit configured to direct writing of data to the memory cells or sensing of the data from the memory cells, a first channel, a second channel, and a third channel, each of the first, second, and third channels comprising at least one pad, and a transceiver configured to transmit the data to an external device or configured to receive the data. The first channel is configured to receive a command and an address, the second channel is configured to transmit and receive the data, and the third channel receives a first control signal, and the control logic circuit is configured to transmit a second control signal enabling the transceiver to a driving circuit in response to receiving a select chip enable packet through the first channel and to direct transmission or reception of the data through the second channel based on the select chip enable packet and the first control signal.

According to an embodiment, a method of operating a non-volatile memory device including a plurality of memory dies sharing a first channel, a second channel, and a third channel includes receiving a first command to direct input of first data to a first memory die or output of the first data from the first memory die through the first channel, receiving a first select chip enable packet to select the first memory die through the first channel, controlling the first memory die to turn on at least one first driving circuit that drives a first transceiver of the first memory die in response to receiving the first select chip enable packet, sensing, by the first memory die, a first transition of a first control signal received through the second channel, controlling the first transceiver to transmit or receive the first data through the third channel based on the first transition.

According to the above, the non-volatile memory device, the method of operating the memory device, and the storage device including the memory device may reduce data input/output overhead.

According to the above, the non-volatile memory device, the method of operating the memory device, and the storage device including the memory device may improve data input/output efficiency.

At least some of the above and other features of the disclosure are set out in the claims.

### BRIEF DESCRIPTION OF THE DRAWINGS

FIG. 1 is a block diagram illustrating a storage device according to an embodiment of the disclosure;
FIG. 2 is a block diagram illustrating a non-volatile memory device according to an embodiment of the disclosure;
FIG. 3 is a block diagram illustrating a memory controller according to an embodiment of the disclosure;
FIG. 4 is a block diagram illustrating a storage device including a plurality of non-volatile memory devices according to an embodiment of the disclosure;
FIG. 5 is a schematic diagram illustrating a memory block having a three-dimensional V-NAND structure applicable to a storage device according to an embodiment of the disclosure;
FIG. 6 is a block diagram illustrating a memory die according to an embodiment of the disclosure;
FIGS. 7 and 8 are timing diagrams illustrating a read sequence of a memory die according to embodiments of the disclosure;
FIG. 9 is a timing diagram illustrating a data output sequence of memory dies according to an embodiment of the disclosure;
FIG. 10 is a timing diagram illustrating a data output sequence of memory dies according to an embodiment of the disclosure;
FIG. 11 is a flowchart illustrating a method of operating a memory device according to an embodiment of the disclosure;
FIG. 12 is a block diagram illustrating a non-volatile memory device according to an embodiment of the disclosure;
FIGS. 13 and 14 are block diagrams illustrating a configuration of non-volatile memory devices according to an embodiment of the disclosure;
FIG. 15 is a block diagram illustrating a storage device including a buffer chip according to an embodiment of the disclosure;
FIG. 16 is a flowchart illustrating a method of operating a storage device including the buffer chip of FIG. 15;
FIG. 17 is a block diagram illustrating a storage device including a buffer chip according to an embodiment of the disclosure; and
FIGS. 18 and 19 are flowcharts illustrating a method of operating a storage device including the buffer chip of FIG. 17.

### DETAILED DESCRIPTION

Below, embodiments of the disclosure will be described in detail and clearly to enable implementation of the disclosure.

In the disclosure, the terms "start" and "end" are used interchangeably with the terms "begin" and "terminate," respectively. The terms "start" and "begin" refer to the initiation of an operation or process, while "end" and "terminate" refer to the conclusion or cessation of an operation or process. The use of these terms is not intended to imply any technical distinction, but rather to convey the commencement and cessation of the described operations. In the disclosure, the terms "enable" and "disable" are used to describe the activation and deactivation of a system or circuit. The term "enable" refers to the activation or turning on of a component, while "disable" refers to the deactivation or turning off of a component. These terms are used consistently to describe the state of the system or circuit at any given time.

In the disclosure, the terms "die" and "chip" may be used interchangeably.

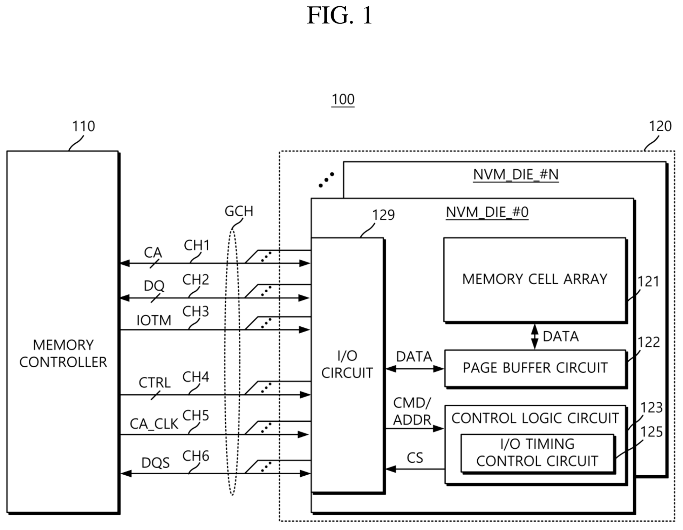

FIG. 1 is a block diagram illustrating a storage device 100 according to an embodiment of the disclosure.

A non-volatile memory device 120 according to an embodiment of the disclosure may input and/or output data based on a first control signal IOTM that defines input/output timing of input and/or output of a data signal DQ through a data channel or a signal channel. A memory controller 110 may transmit the first control signal IOTM to the non-volatile memory device 120 through a separate third channel CH3, which is different from a first channel CH1 that transmits a command address signal CA and a second channel CH2 that transmits the data signal DQ. The non-volatile memory device 120 may transmit and/or receive data through the second channel CH2 based on the first control signal IOTM received through the third channel CH3.

Referring to FIG. 1, the storage device 100 may include the memory controller 110 and the non-volatile memory device 120.

The memory controller 110 may control the memory device 120 to perform input/output requests from a host. The memory controller 110 may control the memory device 120 in response to commands or control from the host. The input/output requests may include writing, reading, and/or erasing of user data that the host requests from the storage device 100. In the disclosure, the expression "writing of data" may be used with the same or a similar meaning as storing or programming data, and the expression "reading of data" may be used with the same or a similar meaning as retrieving or sensing data.

For example, the memory controller 110 may write data to the memory device 120 or may read data stored in the memory device 120 in response to a request from the host. For communication with the memory device 120, the memory controller 110 may provide control signals CTRL, the data signal DQ, the command address signal CA, a command address clock signal CA_CLK, and a data strobe signal DQS to the memory device 120. According to an embodiment, each signal may be transmitted unidirectionally or bidirectionally.

The memory controller 110 may transmit the command address signal CA to the memory device 120 through the first channel CH1 and may transmit and receive the data signal DQ to and from the memory device 120 through the second channel CH2. In an embodiment, the first channel CH1 may be configured as a 2-bit bus, and the second channel CH2 may be configured as an 8-bit bus.

In addition to the signals illustrated in FIG. 1, the memory controller 110 may transmit various other signals to the memory device 120.

In addition to the command address signal CA, the data signal DQ, and the first control signal IOTM, the memory device 120 may transmit and/or receive various additional signals.

For example, referring to FIG. 1, the memory device 120 may receive the control signal CTRL, the command address clock signal CA_CLK, and the data strobe signal DQS through a fourth channel CH4, a fifth channel CH5, and a sixth channel CH6, respectively.

Each channel between the memory controller 110 and the memory device 120 may include at least one pin. For example, the first channel CH1, which transmits the command address signal CA, may include two pins, and the second channel CH2, which transmits the data signal DQ, may include eight or more pins.

The memory device 120 may store data received from the memory controller 110 through the second channel CH2 in a memory cell. In another example, the memory device 120 may sense data stored in the memory cell and may transmit the sensed data to the memory controller 110 through the second channel CH2.

The memory device 120 may be provided as a storage medium for the storage device 100. For example, the memory device 120 may be provided as a NAND-type flash memory having a large storage capacity.

The memory device 120 may include a plurality of non-volatile memory devices. As an example, the memory device 120 may include a plurality of flash memory devices.

FIG. 1 illustrates, as an example, a single non-volatile memory device 120 including N (where N is a natural number greater than or equal to 2) non-volatile memory dies NVM_DIE_#0 through NVM_DIE_#N. However, the disclosure is not limited thereto, and the single non-volatile memory device 120 may include a single non-volatile memory die.

The memory device 120 may include flash memory devices having a two-dimensional (2D) structure or a three-dimensional (3D) structure. The flash memory device may include other types of non-volatile memory, such as a NAND flash memory, a vertical NAND (V-NAND) flash memory, a NOR flash memory, a magnetic RAM (MRAM), a phase-change RAM (PRAM), a ferroelectric random access memory (FRAM), a spin transfer torque random access memory (STT-RAM), and/or a resistive RAM (RRAM).

For example, the flash memory devices may be connected to the memory controller 110 on a per-channel basis. The flash memory devices, which communicate through the same data bus, may be connected to a single channel. The memory device 120 may communicate with the memory controller 110 in a channel/way interleaving manner. Although FIG. 1 illustrates the storage device 100 that outputs the data signal DQ through one signal channel CH2 as an example, the disclosure is not limited thereto.

According to an embodiment, the storage device 100 may include a buffer memory device. The buffer memory device may be used as a data buffer for data exchange between the storage device 100 and the host. Write data provided from the host or read data from the memory device 120 may be temporarily stored in the buffer memory device. In a case where data existing in the memory device 120 is cached upon a read request from the host, the buffer memory device may support a cache function that directly provides the cached data to the host. The buffer memory device may be provided as a synchronous DRAM (SDRAM) to provide sufficient buffering in the storage device 100, which is used as a large-capacity auxiliary storage device. However, the buffer memory device is not limited to the disclosure.

FIG. 1 illustrates the non-volatile memory device 120 including the N non-volatile memory dies NVM_DIE_#0 through NVM_DIE_#N.

In an embodiment, the N non-volatile memory dies NVM_DIE_#0 through NVM_DIE_#N may share channels with each other.

For example, each of the non-volatile memory dies NVM_DIE_#0 through NVM_DIE_#N may transmit the command address signal CA through the same first channel CH1. Pads electrically connected to the first channel CH1 of each of the non-volatile memory dies NVM_DIE_#0 through NVM_DIE_#N may be electrically connected to each other. For example, each of the non-volatile memory dies NVM_DIE_#0 through NVM_DIE_#N may share other channels CH2 through CH6 with each other.

Each of the memory dies NVM_DIE_#0 through NVM_DIE_#N may include a memory cell array 121, a page buffer circuit 122, a control logic circuit 123, and an I/O circuit 129.

The memory cell array 121 may include a plurality of memory blocks, and each of the memory blocks may include a plurality of memory cells.

During a read operation of the memory dies NVM_DIE_#0 through NVM_DIE_#N, the page buffer circuit 122 may sense data stored in the memory cell by detecting a current or a voltage of a selected bit line. The page buffer circuit 122 may temporarily store data sensed from the memory cells.

The control logic circuit 123 may generally control various operations within the memory dies NVM_DIE_#0 through NVM_DIE_#N. For example, in response to a command and an address received from the memory controller 110, the control logic circuit 123 may direct or control writing of data to the memory cells of the memory cell array 121 or may direct or control reading of data from the memory cells.

The page buffer circuit 122 may transmit the sensed data to the I/O circuit 129 to output the data through the second channel CH2. The I/O circuit 129 may channel-encode the data to generate the data signal DQ, and then may transmit the data signal DQ through the second channel CH2. The I/O circuit 129 may output the data signal DQ in alignment with or synchronized with the data strobe signal DQS.

For example, the I/O circuit 129 may sample the data signal DQ received through the second channel CH2 based on the data strobe signal DQS, and the sampled data may be temporarily stored in the page buffer circuit 122 before being programmed into the memory cell array 121.

According to an embodiment of the disclosure, the memory device 120 may transmit or receive the data signal DQ through the second channel CH2 based on a select chip enable (SCE) packet received through the first channel CH1 and the first control signal IOTM received through the third channel CH3. In an embodiment, the select chip enable (SCE) packet may further include a logical unit number (LUN) address, and the logical unit number (LUN) address may correspond to a logical position at which data is stored in the non-volatile memory device.

For example, the memory device 120 may channel-encode data sensed from a memory die corresponding to a chip address included in the select chip enable (SCE) packet received through the first channel CH1 into the data signal DQ, and may start transmission or reception of the data signal DQ through the second channel CH2 based on the first control signal IOTM. Prior to reception of the select chip enable (SCE) packet, data may be sensed from memory cells at an address included in a read command applied to the memory device 120 through the first channel CH1. In an embodiment, the chip address may be a logical unit number (LUN) address.

In the memory device 120 according to an embodiment of the disclosure, an input/output timing control circuit 125 may enable a transceiver of the I/O circuit 129 in response to receiving the select chip enable (SCE) packet received through the first channel CH1.

In the disclosure, the I/O circuit may include a transceiver that transmits and receives the command address signal CA, a transceiver that transmits and receives the data signal DQ, and a transceiver that transmits and receives the first control signal IOTM, and the like. Unless otherwise specified, the transceiver that is enabled in response to receiving the select chip enable packet may be the transceiver that transmits and receives the data signal DQ. In the disclosure, the expression "enabling a transceiver in response to receiving a select chip enable packet (based on the select chip enable packet)" may be used interchangeably with the expression "enabling a transceiver that transmits and receives a data signal DQ in response to receiving a select chip enable packet (based on the select chip enable packet)". The expression "activating a driving circuit that drives a transceiver in response to receiving a select chip enable packet (based on the select chip enable packet)" may be used interchangeably with the expression "activating a driving circuit driving a transceiver that transmits and receives a data signal DQ in response to receiving a select chip enable packet (based on the select chip enable packet)". Further, in the disclosure a signal may be referred to being activated or deactivated, or being in an activated state or deactivated state. Such states may be logical high (or logic level high), or logical low (or logic level low). These may be reversed, i.e., a deactivated state may be logic level low, or high. For example, the activated state may be logic level high while the deactivated state may be logic level low.

In an embodiment, the input/output timing control circuit 125 may transmit an activated second control signal CS to at least one driving circuit that drives the transceiver transmitting and receiving the data signal DQ.

For example, upon receiving the read command and the select chip enable (SCE) packet, the memory device 120 may transmit the activated second control signal CS to at least one driving circuit that drives a transmission circuit of the data signal DQ. When the memory device 120 receives a program command and the select chip enable (SCE) packet, the memory device 120 may transmit the activated second control signal CS to the at least one driving circuit that drives a reception circuit of the data signal DQ.

In an embodiment, the transceiver that transmits and receives the data signal DQ may include the transmission circuit and the reception circuit. The transmission circuit and the reception circuit may include various conventional circuits for signal transmission and/or reception, such as a transmitter, a receiver, an input/output register, an input/output buffer, and a signal transmission circuit. The signal transmission circuit may convert an internal data signal into a transmission data signal to be transmitted through a channel. The signal transmission circuit may include a channel driving circuit.

The at least one driving circuit that drives the transceiver transmitting and receiving the data signal DQ may include a circuit that provides at least one of a driving voltage, a bias voltage, a bias current, a reference voltage, and a reference current to the transceiver for a normal operation of the transceiver, prior to the transceiver's general signal transmission operation of transmitting a signal to a signal path.

In the memory device 120 according to an embodiment of the disclosure, upon receiving the select chip enable (SCE) packet, the input/output timing control circuit 125 may transmit the activated second control signal CS to the driving circuit that drives the transceiver transmitting and receiving the data signal DQ, and the driving circuit may provide at least one of the driving voltage, the bias voltage, the bias current, the reference voltage, and the reference current to the transceiver transmitting and receiving the data signal DQ.

Before the memory controller 110 directs or controls the start of transmission and/or reception of the data signal DQ via the second channel CH2, the transceiver transmitting and receiving the data signal DQ may perform a pre-operation required to be executed for the normal operation prior to the data transmission based on at least one of the driving voltage, the bias voltage, the bias current, the reference voltage, and the reference current. As the pre-operation is performed, the transceiver may be enabled. For example, when the pre-operation is performed, the transceiver may enter a state in which the data transmission and reception are possible. The enabled state of the transceiver may include an enabled state of at least one of the transmission circuit and the reception circuit.

After the memory device 120 receives the select chip enable (SCE) packet, the memory controller 110 may use the first control signal IOTM to direct or control the start of transmission and/or reception of the data signal DQ via the second channel CH2. The I/O circuit 129 of the memory device 120 may output the data signal DQ to the second channel CH2 or may sample the data signal DQ from the second channel CH2 without the pre-operation of the transceiver. Thus, the efficiency of data transmission of the memory device 120 may be improved.

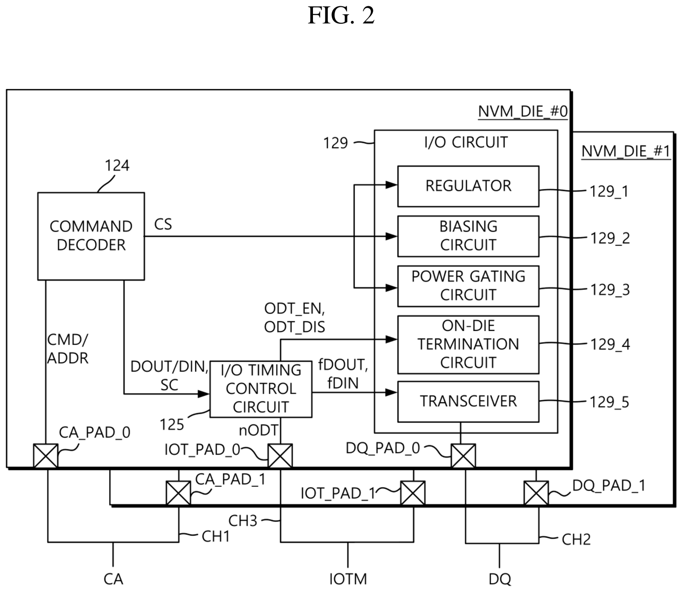

FIG. 2 is a block diagram illustrating the non-volatile memory device according to an embodiment of the disclosure. The non-volatile memory dies NVM_DIE_#0 and NVM_DIE_#1 of FIG. 2 may be any two dies among the non-volatile memory dies NVM_DIE_#0 through NVM_DIE_#N of FIG. 1. Although FIG. 2 illustrates two dies among the non-volatile memory dies NVM_DIE_#0 through NVM_DIE_#N of FIG. 1, the other remaining non-volatile memory dies NVM_DIE_#2 through NVM_DIE_#N may also be configured identically to the non-volatile memory dies NVM_DIE_#0 and NVM_DIE_#1 of FIG. 2, and may share the channels CH1, CH2, and CH3 with the non-volatile memory dies NVM_DIE_#0 and NVM_DIE_#1.

The non-volatile memory dies NVM_DIE_#0 and NVM_DIE_#1 are described with reference to FIG. 2.

Referring to FIG. 2, each of the non-volatile memory dies NVM_DIE_#0 and NVM_DIE_#1 may include a command decoder 124, the input/output timing control circuit 125, and the I/O circuit 129. The configuration of the memory die described with reference to FIG. 2 illustrates the configuration of a first memory die NVM_DIE_#0 as an example. The configuration of a second memory die NVM_DIE_#1 may be the same as or similar to the configuration of the first memory die NVM_DIE_#0.

At least one first pad CA_PAD_0 of the first memory die NVM_DIE_#0 may share the first channel CH1 with at least one first pad CA_PAD_1 of the second memory die NVM_DIE_#1.

At least one second pad DQ_PAD_0 of the first memory die NVM_DIE_#0 may share the second channel CH2 with at least one second pad DQ_PAD_1 of the second memory die NVM_DIE_#1.

At least one third pad IOT_PAD_0 of the first memory die NVM_DIE_#0 may share the third channel CH3 with at least one third pad IOT_PAD_1 of the second memory die NVM_DIE_#1.

The command decoder 124 of the first memory die NVM_DIE_#0 may be electrically connected to the at least one first pad CA_PAD_0. The command address signal CA may be received through the first channel CH1, and a sampler may transmit an internal command address signal CMD/ADDR, which is obtained by sampling the command address signal CA, to the command decoder 124.

The command decoder 124 may decode the select chip enable (SCE) packet received through the first channel CH1 and may determine whether the first memory die NVM_DIE_#0 is a target die. The command decoder 124 may store whether the first memory die NVM_DIE_#0 is a target die (hereinafter, referred to as a target die status SC of the first memory die NVM_DIE_#0) in an internal register.

For example, the select chip enable (SCE) packet may be a select chip enable packet based on a separate command address (SCA) protocol, and the select chip enable (SCE) packet may include a chip address in a body of the select chip enable packet. The first memory die NVM_DIE_#0 may compare the chip address of the select chip enable packet with an address of the first memory die NVM_DIE_#0 or with an address of any one of the chips included in the first memory die NVM_DIE_#0 and may determine whether the first memory die NVM_DIE_#0 is the target die.

When the first memory die NVM_DIE_#0 is the target die, the command decoder 124 of the first memory die NVM_DIE_#0 may transmit the activated second control signal CS to the I/O circuit 129.

In an embodiment, as described with reference to FIG. 1, a transceiver 129_5 of the first memory die NVM_DIE_#0 may be enabled by the activated second control signal CS.

In an embodiment, the command decoder 124 may transmit the activated second control signal CS to one of the driving circuits of the I/O circuit 129. The driving circuit may be a circuit that drives the transceiver 129_5. For example, the driving circuit may include a circuit that provides at least one of the driving voltage, the bias voltage, the bias current, the reference voltage, and the reference current to the transceiver 129_5 for the normal operation of the transceiver 129_5 before the transceiver 129_5 performs channel encoding of data.

Referring to FIG. 2, the I/O circuit 129 may include a regulator 129_1, a biasing circuit 129_2, a power gating circuit 129_3, an on-die termination circuit 129_4, and the transceiver 129_5.

In an embodiment, at least one driving circuit that drives the transceiver 129_5 may include the regulator 129_1 that directly or indirectly supplies the driving voltage obtained by voltage-dropping an external supply voltage to the transceiver. The regulator 129_1 may be a low dropout (LDO) regulator. The regulator 129_1 may be electrically connected to the transceiver 129_5.

In an embodiment, at least one driving circuit that drives the transceiver 129_5 may include the biasing circuit 129_2 to provide the bias voltage and/or the bias current to at least one of the transmission circuit and the reception circuit. Upon receiving the activated second control signal CS, the biasing circuit 129_2 may begin providing the bias voltage and/or the bias current to the transceiver 129_5. The biasing circuit 129_2 may be electrically connected to the transceiver 129_5.

In an embodiment, at least one driving circuit that drives the transceiver 129_5 may include the power gating circuit 129_3 that directly or indirectly connects at least one of the transmission circuit and the reception circuit to either an input/output supply voltage node or a ground node and may gate power supplied to at least one of the transmission circuit and the reception circuit. Upon receiving the activated second control signal CS, the power gating circuit 129_3 may stop gating the supply power. Thus, the supply power may be provided to the transceiver 129_5. The power gating circuit 129_3 may be electrically connected to the transceiver 129_5.

At least one driving circuit that drives the transceiver 129_5 may include circuits other than the regulator 129_1, the biasing circuit 129_2, and the power gating circuit 129_3 described with reference to FIG. 2.

In an embodiment, at least one driving circuit that drives the transceiver 129_5 may include a reference providing circuit that provides the reference voltage and/or the reference current for a signal comparison operation to at least one of the transmission circuit and the reception circuit. Upon receiving the activated second control signal CS, the reference providing circuit may begin providing the reference voltage and/or the reference current to the transceiver 129_5.

For example, at least one driving circuit that drives the transceiver 129_5 may include various circuits required for a pre-driving operation to enable the transceiver 129_5 to be in a state capable of transmitting and receiving data.

The transceiver 129_5 may be enabled by the at least one driving circuit that drives the transceiver 129_5.

The input/output timing control circuit 125 of the first memory die NVM_DIE_#0 may be electrically connected to at least one third pad IOT_PAD_0. The first control signal IOTM may be received through the third channel CH3, and the sampler may transmit an internal first control signal nODT, which is obtained by sampling the first control signal IOTM, to the input/output timing control circuit 125. In an embodiment, the first control signal IOTM may be a data burst signal that indicates the start point and/or end point of the data output and/or input.

The command decoder 124 may transmit the target die status SC, a data output command DOUT, and a data input command DIN to the input/output timing control circuit 125.

The data output command DOUT may be an internal command that directs an output of the sensed data to the data signal DQ via the second channel CH2. In an embodiment, the command decoder 124 may sense data from the memory cell array based on the read command received via the first channel CH1, and may generate the internal data output command DOUT based on the data output command received via the first channel CH1. For example, the data output command received via the first channel CH1 may be a "change read column" command of Joint Electron Device Engineering Council (JEDEC) standard, but the disclosure is not limited thereto.

The data input command DIN may be an internal command that directs the reception of the data signal DQ via the second channel CH2. In an embodiment, the command decoder 124 may generate the internal data input command DIN based on the program command received via the first channel CH1. For example, the program command received via the first channel CH1 may be a "program" command of the JEDEC standard, but the disclosure is not limited thereto.

In a case where the select chip enable (SCE) packet is received after the first memory die NVM_DIE_#0 generates the internal data input command DIN and the internal data output command DOUT based on commands received from an external source, the first memory die NVM_DIE_#0 may not immediately begin the transmission and reception of the data signal DQ via the second channel CH2.

In the state where the transceiver 129_5 is enabled in response to the select chip enable (SCE) packet, the first memory die NVM_DIE_#0 may receive the first control signal IOTM via the third channel CH3. In the state where the transceiver 129_5 is enabled, when the transmission and reception of the data signal DQ is directed by the first control signal IOTM, the first memory die NVM_DIE_#0 may begin the transmission and reception of the data signal DQ through the second channel CH2.

Referring to FIG. 2, the input/output timing control circuit 125 may receive the target die status SC of the first memory die NVM_DIE_#0, the internal data output command DOUT, and the internal data input command DIN from the command decoder 124. The input/output timing control circuit 125 may receive an activated internal first control signal nODT. The activated internal first control signal nODT may be based on the activated first control signal IOTM received through the third pad IOT_PAD_0.

Based on the activated internal first control signal nODT, the input/output timing control circuit 125 may transmit internal signals fDOUT and fDIN, which direct or control the transmission and reception of the data signal DQ via the second channel CH2, to the transceiver 129_5. The transceiver 129_5 may receive the internal signals fDOUT and fDIN and may begin the transmission and reception of the data signal DQ.

After beginning the transmission and reception of the data signal DQ, the first memory die NVM_DIE_#0 may receive a deactivated first control signal IOTM. The input/output timing control circuit 125 may receive an internal deactivated first control signal nODT based on the deactivated first control signal IOTM. The input/output timing control circuit 125 may transmit internal signals fDOUT and fDIN, which direct or control the termination of the transmission and reception of the data signal DQ via the second channel CH2, to the transceiver 129_5. The transceiver 129_5 may receive the internal signals fDOUTand fDIN and may terminate the transmission and reception of the data signal DQ

As described with reference to FIG. 2, the first memory die NVM_DIE_#0 may identify the target die status based on the select chip enable (SCE) packet, but may not immediately begin the transmission and reception of the data signal DQ in response to receiving the select chip enable (SCE) packet. The first memory die NVM_DIE_#0 may determine the start and end of the transmission and reception of the data signal DQ based on the first control signal IOTM received via the third channel CH3. The first memory die NVM_DIE_#0 may determine to the start and/or end of the transmission and/or reception of the data signal DQ based on the first control signal IOTM received via the third channel CH3.

In an embodiment, the input/output timing control circuit 125 may determine the start and end of an on-die termination based on the first control signal IOTM received via the third channel CH3.

For example, when the input/output timing control circuit 125 receives the activated first control signal IOTM, the input/output timing control circuit 125 may transmit a signal ODT_EN that directs the enabling of a non-target on-die termination to a non-target die. When the input/output timing control circuit 125 receives the activated first control signal IOTM, the input/output timing control circuit 125 may transmit a signal ODT_DIS that directs the disabling of the non-target on-die termination to the non-target die in which the on-die termination is enabled.

According to an embodiment, the target die may also enable a target on-die termination. According to another embodiment, either the transmission circuit or the reception circuit of the target die may be terminated. For example, an impedance level of an on-die termination circuit 129_4 connected to either the transmission circuit or the reception circuit of the target die may be set to a termination level.

In an embodiment, the enabling and the disabling of the on-die termination may be performed by changing an impedance level of the on-die termination circuit 129_4. For example, the first memory die NVM_DIE_#0 may pre-store a plurality of impedance levels corresponding to whether the first memory die NVM_DIE_#0 is a target die and/or the non-target die. The first memory die NVM_DIE_#0 may change the impedance level of the on-die termination circuit 129_4 of the target die and/or the non-target die to one of the impedance levels. The target die may be a memory die that corresponds to the chip address of the select chip enable (SCE) packet. The non-target die may be a memory die that does not correspond to the chip address of the select chip enable (SCE) packet.

The memory dies NVM_DIE_#0 and NVM_DIE_#1 may perform the on-die termination based on various conventional methods to enable and disable the on-die termination, and the disclosure is not limited to the termination method disclosed herein.

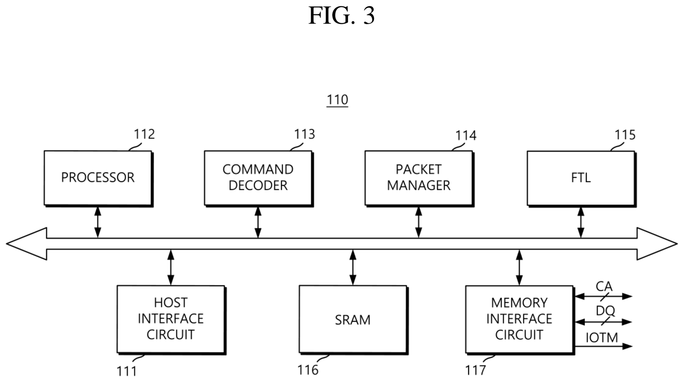

FIG. 3 is a block diagram illustrating a memory controller 110 according to an embodiment of the disclosure. The memory controller 110 described with reference to FIG. 3 may correspond to the memory controller 110 of FIG. 1.

The memory controller 110 may include a host interface circuit 111, a processor 112, a command decoder 113, a packet manager 114, a flash translation layer 115, an SRAM 116, and a memory interface circuit 117.

The memory controller 110 may communicate with a host through the host interface circuit 111. The host interface circuit 111 may be implemented using various interface standards, such as Advanced Technology Attachment (ATA), Serial ATA (SATA), external Serial ATA (eSATA), Small Computer System Interface (SCSI), Serial Attached SCSI (SAS), Peripheral Component Interconnect (PCI), PCI Express (PCIe), IEEE 1394, Universal Serial Bus (USB), Non-Volatile Memory Express (NVMe), and Compute Express Link (CXL).

The processor 112 may be implemented as a circuit, logic, code, or a combination thereof. The processor 112 may generally control the operation of the storage device 100 including the memory controller 110. When the storage device 100 is powered on, the processor 112 may load firmware stored in a read-only memory (ROM) to a working memory device and may perform the overall operation of the memory controller 110. The processor 112 may load the flash translation layer (FTL) 115 to the working memory, and based on an address translation result of the flash translation layer 115, may program data into the memory device 120 and/or may read data from the memory device 120.

The command decoder 113 may decode a command parsed from a packet received from the host based on a protocol of an interface agreed with the host. For example, the command decoder 113 may decode an opcode of a command based on a specific protocol and may distinguish between a program command, an erase command, a read command, and/or a secure erase command. The processor 112 may perform a request from the host according to the decoded commands. In an embodiment, the command decoder 113 may be implemented as an independent circuit and/or as a part of firmware.

The flash translation layer 115 may perform various functions, such as address mapping, wear-leveling, and garbage collection.

The address mapping operation may be an operation that converts a logical address received from the host into a physical address used to program data in the memory device 120 of FIG. 1. For example, a logical block address (LBA) of user data requested for programming by the host may be converted into a physical address of the memory device 120 of FIG. 1 using the flash translation layer 115. In an embodiment, the physical address may be a physical page number (PPN). In an embodiment, an address mapping table managed by the flash translation layer 115 may store a mapping relationship between a logical page number (LPN) and the physical page number (PPN). In an embodiment, each logical page number (LPN) may correspond to a plurality of logical block addresses (LBAs).

The wear-leveling may be a technique to prevent excessive degradation of a specific block by ensuring that the blocks of the non-volatile memory dies NVM_DIE_#0 through NVM_DIE_#N of the memory device 120 in FIG. 1 may be used uniformly. For example, the wear-leveling may be implemented through a firmware technique that balances erase counts of the physical blocks. The garbage collection may be a technique to secure available capacity in the memory device 120 of FIG. 1 by copying valid data from a block to a new block and then erasing an original block.

The SRAM 116 may store temporary data and temporary variables for the operation of the processor 112.

The memory interface circuit 117 may provide an interface between the memory controller 110 and the memory device 120. For example, data processed by the processor 112 and/or the packet manager 114 may be written to the memory device 120 through the memory interface circuit 117. As another example, data stored in the memory device 120 of FIG. 1 may be output to the memory controller 110 through the memory interface circuit 117.

The memory interface circuit 117 may communicate with the memory device 120 using the separate command address (SCA) protocol. For example, the memory interface circuit 117 may communicate with the memory device 120 of FIG. 1 using the first channel that transmits the command address signal CA and the second channel that transmits the data signal DQ.

The memory interface circuit 117 may transmit the first control signal IOTM via the third channel. The processor 112 may direct or control the memory interface circuit 117 to transmit the first control signal IOTM through the third channel to indicate the start and end of transmission and reception of the data signal DQ through the second channel of the memory device 120 of FIG. 1.

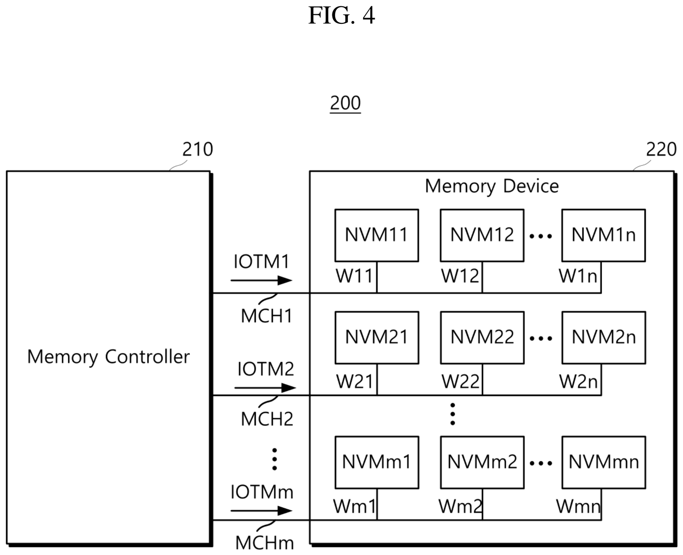

FIG. 4 is a block diagram illustrating a storage device 200 including a plurality of non-volatile memory dies according to an embodiment of the disclosure.

A memory controller 210 may perform input/output operations on a plurality of non-volatile memory devices NVM11 to NVMmn through a plurality of channels MCH1 to MCHm. A memory device 220 and the memory controller 210 may be connected to each other through the channels MCH1 to MCHm. In an embodiment, the memory controller 210 may include a plurality of controller modules corresponding to respective channels. Each of the channels MCH1 to MCHm may include individual channels CH1 to CH6 described with reference to FIG. 1.

The memory controller 210 may control each of the non-volatile memory devices NVM11 to NVMmn, which is connected to one of the channels MCH1 to MCHm via a way.

The memory controller 210 may transmit and receive signals to and from the memory device 220 through the channels MCH1 to MCHm.

The memory device 220 may include the non-volatile memory devices NVM11 to NVMmn. Each of the non-volatile memory devices NVM11 to NVMmn may be a non-volatile memory package. In an embodiment, each of the non-volatile memory devices NVM11 to NVMmn may include a plurality of dies, but the disclosure is not limited thereto.

The memory device 220 may receive a first command for an interleaving operation between the non-volatile memory devices connected to the same channel.

For example, the memory controller 210 may transmit the first command to each of the non-volatile memory devices NVM11, NVM12 through NVM1n to read data from each of the non-volatile memory devices NVM11, NVM12 through NVM1n connected to a first channel MCH1. The memory controller 210 may transmit a read command to each of the non-volatile memory devices NVM11, NVM12 through NVM1n and may also transmit the first command to each of the non-volatile memory devices NVM11, NVM12 through NVM1n. Each of the non-volatile memory devices NVM11, NVM12 through NVM1n may operate in an interleaving manner in response to the first command.

The memory controller 210 may transmit different first control signals IOTM1, IOTM2 through IOTMm for respective channels MCH1 to MCHm. One of the non-volatile memory devices connected to the same channel may enable a transceiver for data signal transmission based on a select chip enable (SCE) packet, and in the state where the transceiver is enabled, may begin transmitting and receiving a data signal to and from the channel based on the corresponding first control signal.

Each of the non-volatile memory devices NVM11, NVM12 through and NVM1n may pre-enable the transceiver based on the select chip enable (SCE) packet and may begin the transmission and reception of the data signal to and from the channel based on the separate first control signal. Therefore, data input/output efficiency may be improved compared to enabling the transceiver after being directed to begin the transmission and reception of the data signal to and from the channel.

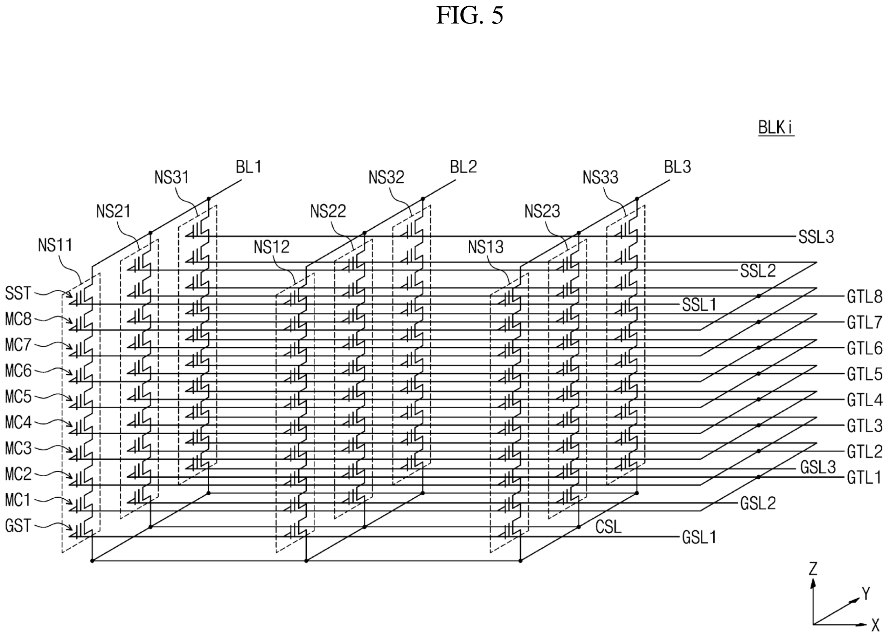

FIG. 5 is a schematic diagram illustrating a memory block having a three-dimensional V-NAND structure applicable to a storage device according to an embodiment of the disclosure. The memory block BLKi of FIG. 5 may be one of the memory blocks included in the memory cell array 121 of the memory device 120 of FIG. 1.

When the memory device 120 of the storage device 100 illustrated in FIG. 1 is implemented as a three-dimensional (3D) V-NAND type flash memory, each of the memory blocks constituting the non-volatile memory may be represented by an equivalent circuit as illustrated in FIG. 5.

The memory block BLKi illustrated in FIG. 5 represents a three-dimensional memory block formed in a three-dimensional structure on a substrate. For example, a plurality of memory NAND strings included in the memory block BLKi may be formed in a direction (e.g., Z-axis direction) perpendicular to the substrate.

Referring to FIG. 5, the memory block BLKi may include a plurality of memory NAND strings NS11 to NS33 connected between a common source line CSL and bit lines BL1, BL2, and BL3. Each of the memory NAND strings NS11 to NS33 may include a string selection transistor SST, a plurality of memory cells MC1, MC2, ..., MC8, and a ground selection transistor GST. Although FIG. 5 illustrates the structure in which each of the memory NAND strings NS11 to NS33 includes eight memory cells MC1, MC2, ..., MC8, the disclosure is not limited thereto.

The string selection transistor SST may be connected to a corresponding string select line SSL1, SSL2, or SSL3. The memory cells MC1, MC2, ..., MC8 may be connected to corresponding gate lines GTL1, GTL2, ..., GTL8, respectively. The gate lines GTL1, GTL2, ..., GTL8 may correspond to word lines extending in a direction (e.g., X-axis direction) parallel to the substrate, and some of the gate lines GTL1, GTL2, ..., GTL8 may correspond to dummy word lines. The ground selection transistor GST may be connected to a corresponding ground select line GSL1, GSL2, or GSL3. The string selection transistor SST may be connected to a corresponding bit line BL1, BL2, or BL3 extending in a direction (e.g., Y-axis direction) parallel to the substrate, which is different from the X-axis direction, and the ground selection transistor GST may be connected to the common source line CSL.

Word lines at the same height (for example, WL1) may be connected in common, and the ground select lines GSL1, GSL2, and GSL3 and the string select lines SSL1, SSL2, and SSL3 may be separated from each other. Although FIG. 5 illustrates the memory block BLKi being connected to eight gate lines GTL1 to GTL8 and three bit lines BL1 to BL3, the number of gate lines and the number of bit lines are not limited thereto.

The memory block BLKi may have different bit densities depending on the number of bits stored in the memory cells included in the memory block BLKi.

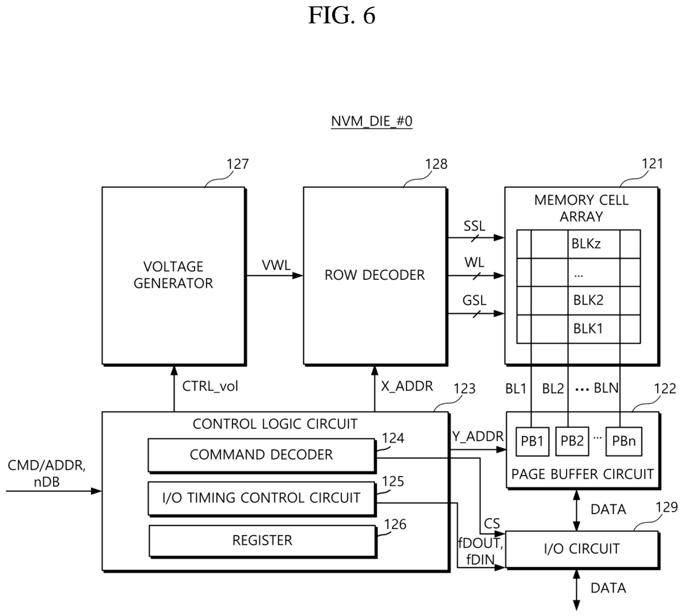

FIG. 6 is a block diagram illustrating the memory die NVM_DIE_#0 according to an embodiment of the disclosure. The memory die NVM_DIE_#0 described with reference to FIG. 6 may correspond to the memory die NVM_DIE_#0 of the memory device 120 illustrated in FIG. 1. Descriptions identical or similar to those described with reference to FIG. 2 will be omitted.

Referring to FIG. 6, the memory die NVM_DIE_#0 may include the memory cell array 121, a voltage generator 127, a row decoder 128, the control logic circuit 123, the page buffer circuit 122, and the I/O circuit 129.

The control logic circuit 123 may control overall operations in the memory die NVM_DIE_#0. The control logic circuit 123 may output various control signals in response to a command CMD and/or an address ADDR from the memory interface circuit. For example, the control signals may include a voltage control signal CTRL_vol, a row address X_ADDR, and a column address Y_ADDR.

The memory cell array 121 may include a plurality of memory blocks BLK1 to BLKz (where z is a positive integer), and each of the memory blocks BLK1 to BLKz may include a plurality of memory cells. The memory blocks BLK1 to BLKz may be connected to the page buffer circuit 122 through bit lines BL1 to BLn and may be connected to the row decoder 128 through word lines WL, string select lines SSL, and ground select lines GSL.

The page buffer circuit 122 may include a plurality of page buffers PB1 to PBn (where n is an integer of 3 or more). The page buffers PB1 to PBn may be connected to the memory cells in the memory blocks BLK1 to BLKz through the bit lines BL1 to BLn. Each of the page buffers PB1 to PBn may include a latch. In response to the column address Y_ADDR, the page buffer circuit 122 may select at least one bit line among the bit lines BL1 to BLn. The page buffer circuit 122 may operate as a write driver or a sense amplifier depending on an operation mode. For example, during a program operation, the page buffer circuit 122 may apply a bit line voltage corresponding to data DATA to be programmed to the selected bit line. During the read operation, the page buffer circuit 122 may sense the current or voltage of the selected bit line to sense the data stored in the memory cell. The page buffers PB1 to PBn of the page buffer circuit 122 may sense the data stored in the memory cells through the bit lines BL1 to BLn and may temporarily store the sensed data.

The voltage generator 127 may generate various levels of voltages to perform operations, such as a program operation, a read operation, and a erase operation based on the voltage control signal CTRL_vol.

The row decoder 128 may select one of the word lines WL and one of the string select lines SSL in response to the row address X_ADDR.

The control logic circuit 123 may include the command decoder 124, the input/output timing control circuit 125, and a register 126.

As in the embodiment described with reference to FIG. 2, a command decoder 124 may receive the internal command address signal CMD/ADDR corresponding to the select chip enable (SCE) packet and may transmit the second control signal CS to the I/O circuit 129 based on the chip address. Based on the activated second control signal CS, the I/O circuit 129 may enable the transceiver to transmit the data signal.

The control logic circuit 123 may store the target die status in the register 126 based on the chip address of the select chip enable (SCE) packet.

The input/output timing control circuit 125 may transmit the internal signals fDOUT and fDIN, which direct or control the transmission and reception of the data signal DQ, to the I/O circuit 129 based on the internal first control signal nODT.

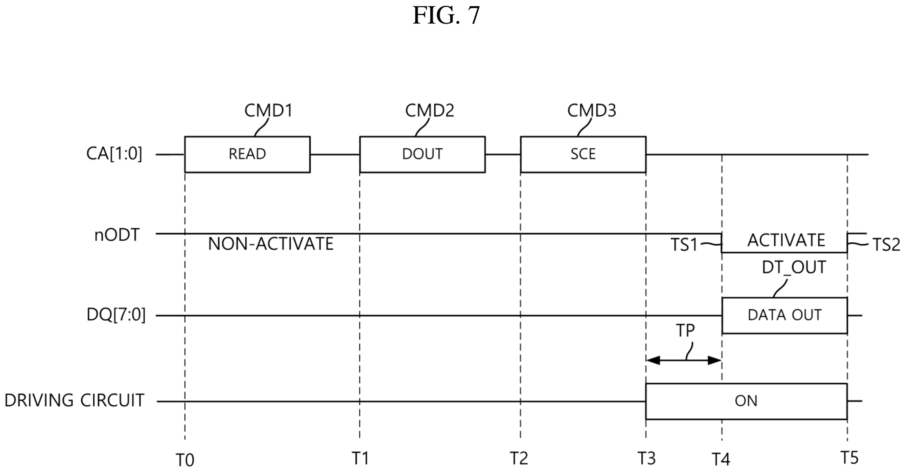

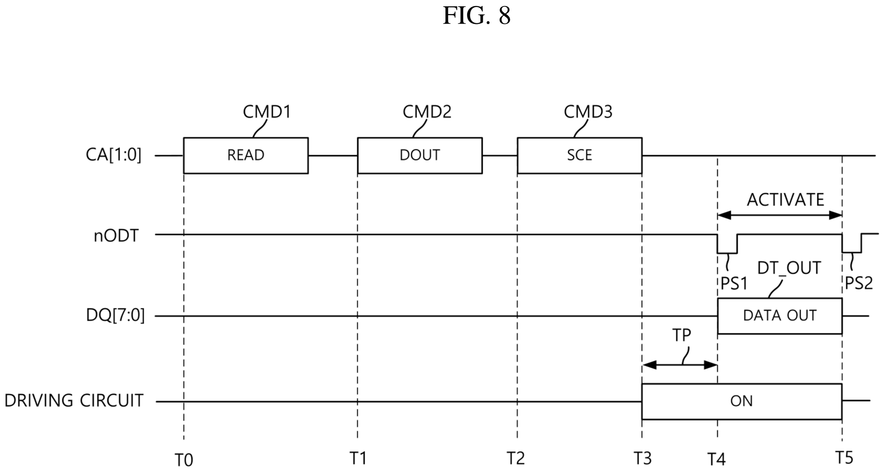

FIGS. 7 and 8 are timing diagrams illustrating a read sequence of the memory die according to embodiments of the disclosure.

FIG. 7 illustrates the activation of the internal first control signal nODT by different transitions TS1 and TS2. FIG. 8 illustrates the activation of the internal first control signal nODT by pulses PS1 and PS2 received at different time points. The activated first control signal, described previously with reference to FIGS. 1 to 6, may be defined by transitions as in the embodiment of FIG. 7, or may be defined by pulses received at different time points as in the embodiment of FIG. 8.

The read sequence of the memory die will be described with reference to FIG. 7.

The memory die may receive a read command CMD1 from the memory controller at a time point T0.

At a time point T1, the memory die may receive an output command CMD2 from the memory controller, which directs the output of the data sensed from the memory cell by the read command CMD1 to the channel.

At a time point T2, the memory die may receive a select chip enable (SCE) packet CMD3, which includes a chip address, via a data signal channel DQ[7:0]. The chip address may be the address of the memory die directed by the memory controller to output the data signal. The read command CMD1, output command CMD2, and/or select chip enable (SCE) packet CMD3 may be received on the described first channel CH1.

However, since the internal first control signal nODT is in a deactivated state, the memory die may not start outputting the data signal in response to the select chip enable packet CMD3, unlike comparable alternative technologies. For example, the memory die may activate the driving circuit that enables the transceiver for data signal transmission at a time point T3 in response to receiving the select chip enable packet CMD3. The transceiver may be enabled for a preparation period TP.

At a time point T4, the internal first control signal nODT may undergo a first transition TS1 to an activated state, or may transition to the activated state at the first transition TS1. In response to the activated internal first control signal nODT, the memory die corresponding to the chip address of the select chip enable packet CMD3 may output the data signal DT_OUT to the data signal channel DQ[7:0]. The data signal DT_OUT may be output on the described second channel CH2.

At a time point T5, the internal first control signal nODT may undergo a second transition (TS2) to a deactivated state or may transition to the deactivated state at the second transition TS2. In response to the internal first control signal nODT in the deactivated state, the memory die corresponding to the chip address of the select chip enable packet CMD3 may stop the output of the data signal DT_OUT to the data signal channel DQ[7:0].

In FIG. 8, the read sequence of the memory die according to an embodiment of the disclosure is described. Descriptions identical or similar to those of FIG. 7 will be omitted, and the following description will focus on differences therebetween.

Referring to FIG. 8, the memory die may receive a first pulse having a preset first pulse width at a time point T4. The memory die corresponding to a chip address of the select chip enable packet CMD3 may output the data signal DT_OUT to a data signal channel DQ[7:0] in response to the internal first control signal nODT activated by the first pulse. The data signal DT_OUT may be output on the described second channel CH2.

At a time point T5, the memory die may receive a second pulse having the preset first pulse width. The memory die corresponding to the chip address of the select chip enable packet CMD3 may stop the output of the data signal DT_OUT to the data signal channel DQ[7:0] in response to the internal first control signal nODT that is deactivated by the second pulse.

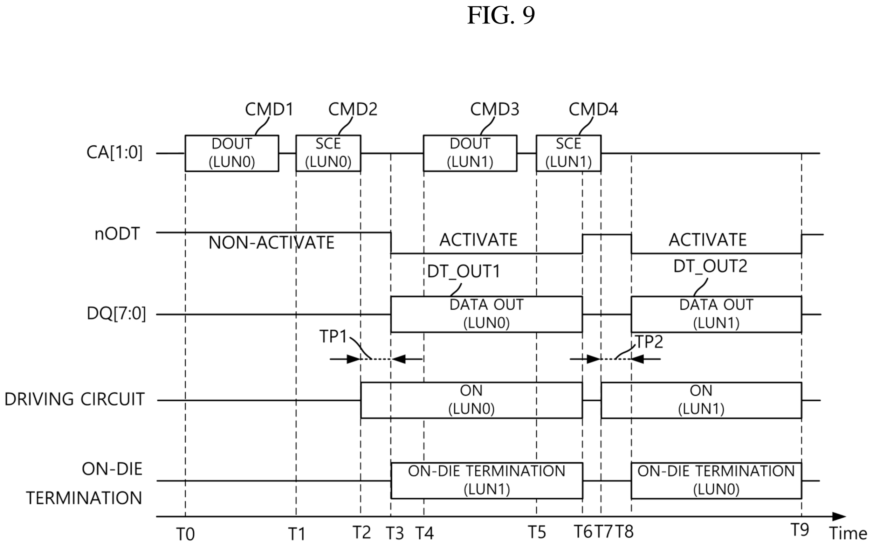

FIG. 9 is a timing diagram illustrating a data output sequence of memory dies according to an embodiment of the disclosure. Descriptions identical or similar to those described with reference to FIGS. 1 to 8 will be omitted.

The embodiment of FIG. 9 is described, for example, on the premise that each of the memory dies is distinguished by a separate chip address. However, the embodiment of FIG. 9 does not exclude the case where each of the memory dies of the disclosure includes a plurality of logical unit numbers (LUNs).

In the embodiment of FIG. 9, the activated internal first control signal nODT may be defined in the same form as the internal first control signal nODT of the embodiment of FIG. 7, but this is an example and does not exclude a case where the activated internal first control signal nODT is defined by a pulse in the embodiment of FIG. 8.

At a time point T0, the memory dies may receive an output command CMD1 that directs the output of sensed data of a first memory die to a channel. In some embodiments, the data of the first memory die may be sensed from the memory cells by a separate read command prior to the time point T0. The output command CMD1 may be received on the described first channel CH1.

At a time point T1, the memory dies may receive a first select chip enable packet CMD2 that includes a LUN address of the first memory die. The first select chip enable packet CMD2 may be received on the described first channel CH1.

At a time point T2, the first memory die corresponding to the chip address of the first select chip enable packet CMD2 may enable the transceiver for the data signal transmission. For example, an activated control signal may be transmitted to a driving circuit of the first memory die that drives the transceiver for the data signal transmission. During a first preparation period TP1, the driving circuit of the first memory die may provide at least one of a driving voltage, a bias voltage, a bias current, a reference voltage, and a reference current to the transceiver of the first memory die. The transceiver of the first memory die may be enabled by at least one of the driving voltage, the bias voltage, the bias current, the reference voltage, and the reference current during the first preparation period TP1.

At a time point T3, the internal first control signal nODT may be activated. Based on the activated internal first control signal nODT, the first memory die may output a data signal DT_OUT1 to the data signal channel DQ[7:0]. A second memory die, which is a non-target die, may perform on-die termination based on the activated internal first control signal nODT. The data signal DT_OUT1 may be output on the described second channel CH2.

At a time point T4, the first memory die and the second memory die may receive an output command CMD3 that directs the output of the sensed data of the second memory die to the channel. In some embodiments, the data of the second memory die may be sensed from the memory cells by a separate read command prior to the time point T0. In an embodiment, the time point, at which the output command CMD3 is received, may be during the period when the output of data from the first memory die is in progress. The output command CMD3 may be received on the described first channel CH1.

At a time point T5, the first memory die and the second memory die may receive a second select chip enable packet CMD4 which includes the chip address of the second memory die. At least a portion of a time period, during which the second select chip enable packet CMD4 is received, may overlap a time period, during which the transceiver for the data signal transmission of the first memory die is enabled by the previous first select chip enable packet CMD2. For example, at least a portion of the time period, during which the second select chip enable packet CMD4 is received, may overlap the time period, during which the driving circuit of the transceiver for the data signal transmission of the first memory die is activated by the previous first select chip enable packet CMD2. The second select chip enable packet CMD4 may be received on the described first channel CH1.

At a time point T6, due to deactivation of the internal first control signal nODT, the first memory die may stop the output of data DT_OUT1, and the driving circuit of the transceiver for the data signal transmission of the first memory die may also be deactivated. The transceiver of the first memory die may be disabled. The second memory die, which is the non-target die, may stop performing the on-die termination.

At a time point T7, the second memory die corresponding to the chip address of the second select chip enable packet CMD4 may enable the transceiver for the data signal transmission. During a second preparation period TP2, the transceiver of the second memory die may be enabled by at least one of a driving voltage, a bias voltage, a bias current, a reference voltage, and a reference current.

At a time point T8, the internal first control signal nODT may be activated again. Based on the reactivated internal first control signal nODT, the second memory die may output the data signal DT_OUT2 to the data signal channel DQ[7:0]. Based on the activated internal first control signal nODT, the first memory die, which is a non-target die, may perform the on-die termination. The data signal DT_OUT2 may be output on the described second channel CH2.

At a time point T9, due to deactivation of the internal first control signal nODT, the second memory die may stop the output of data signal DT_OUT2.

When comparing the memory die of FIG. 9 with alternative related technologies, the memory die may start and end the on-die termination based on the internal first control signal nODT. The memory die may start or end the data transmission based on the internal first control signal nODT. The memory die may not require the transmission of a command indicating the start of on-die termination, a command indicating the end of on-die termination, or a command corresponding to a chip select disable packet. Thus, overhead due to the command transmission may be reduced. Further, the memory die may enable the transceiver for the data signal transmission based on the select chip enable (SCE) packet. The memory die may enable the transceiver for the data signal transmission based on the select chip enable (SCE) packet before the data transmission based on the internal first control signal nODT begins. Therefore, the memory die may start the data transmission immediately based on the internal first control signal nODT.

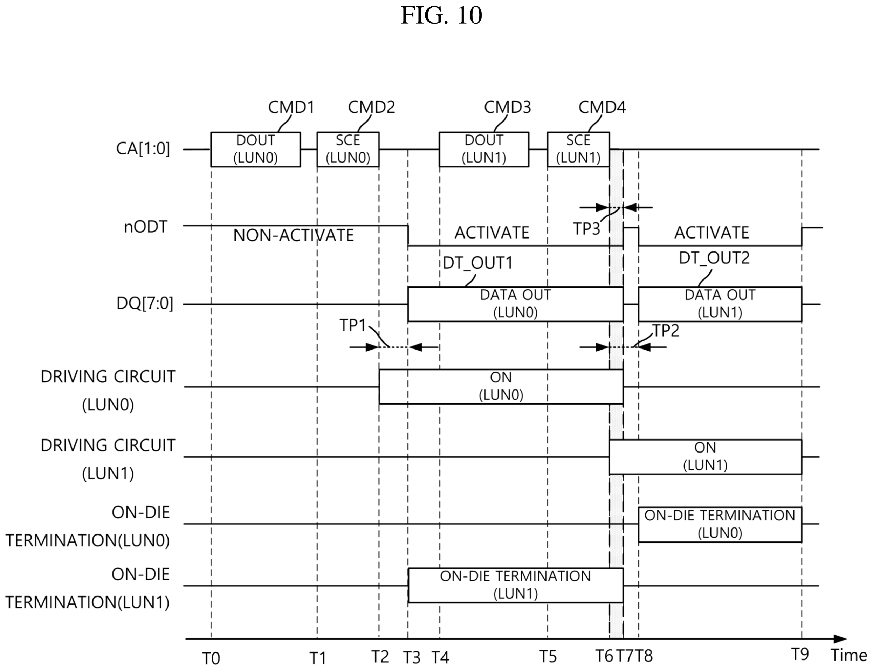

FIG. 10 is a timing diagram illustrating a data output sequence of memory dies according to an embodiment of the disclosure. Descriptions identical or similar to those described with reference to FIG. 9 will be omitted.

The first memory die and the second memory die may operate identically to the embodiment of FIG. 9 at time points T0 to T5.

Unlike the embodiment of FIG. 9, the reception of a second select chip enable packet CMD4 by the first memory die and the second memory die may be completed at a time point T6. For example, the reception of the second select chip enable packet CMD4 may be completed during a period in which the output of a data signal DT_OUT1 from a first memory die to a data signal channel DQ[7:0] is in progress. In response to the reception of the second select chip enable packet CMD4, a second memory die corresponding to a LUN address of the second select chip enable packet CMD4 may enable its own transceiver. During a second preparation period TP2, the transceiver for the data signal transmission of the second memory die may be enabled by at least one of the driving voltage, the bias voltage, the bias current, the reference voltage, and the reference current. Therefore, during a time period TP3 between the time point T6 and a time point T7, both the transceiver for the data signal transmission of the first memory die and the transceiver for the data signal transmission of the second memory die may be in an enabled state. For example, both a driving circuit of the transceiver for the data signal transmission of the first memory die and a driving circuit of the transceiver for the data signal transmission of the second memory die may be in an activated state.

At the time point T7, due to deactivation of the internal first control signal nODT, the first memory die may stop the output of data signal DT_OUT1, and the driving circuit of the transceiver of the first memory die for the data signal transmission may be also deactivated. The transceiver of the first memory die for the data signal transmission may be disabled. The second memory die, which is a non-target die, may stop performing the on-die termination.

At a time point T8, the internal first control signal nODT may be activated again. Based on the reactivated internal first control signal nODT, the second memory die may output the data signal DT_OUT2 to the data signal channel DQ[7:0]. Based on the activated internal first control signal nODT, the first memory die, which is a non-target die, may perform the on-die termination.

At a time point T9, the second memory die may stop the output of data signal DT_OUT2 in response to the internal first control signal nODT that is deactivated again.

When comparing the memory die of FIG. 10 with alternative related technologies, the memory die may perform the start and end of the on-die termination based on a internal first control signal nODT. The memory die may also start or end the data transmission based on the internal first control signal nODT. The memory die may enable the transceiver for the data signal transmission based on the select chip enable (SCE) packet. The memory die may enable the transceiver for the data signal transmission based on the select chip enable (SCE) packet before the data transmission based on the internal first control signal nODT begins. During a period in which data transmission by one memory die is in progress, the select chip enable (SCE) packet indicating another memory die may be transmitted through a command address signal channel CA[1:0].

For example, both the transceiver of a first memory die LUN0 and the transceiver for data signal transmission of a second memory die LUN1 may be in an enabled state during a time period TP3. Therefore, during a period in which the data transmission by one memory die is in progress, the transceiver for data signal transmission of another memory die may be enabled. As a result, the memory dies may start the data transmission immediately based on the internal first control signal nODT. Thus, the second memory die LUN1 may perform at least a portion of the operation of enabling the transceiver for the data signal transmission during the data output of the first memory die LUN0, and thus, the I/O efficiency of the command address signal and the data I/O efficiency may be improved.

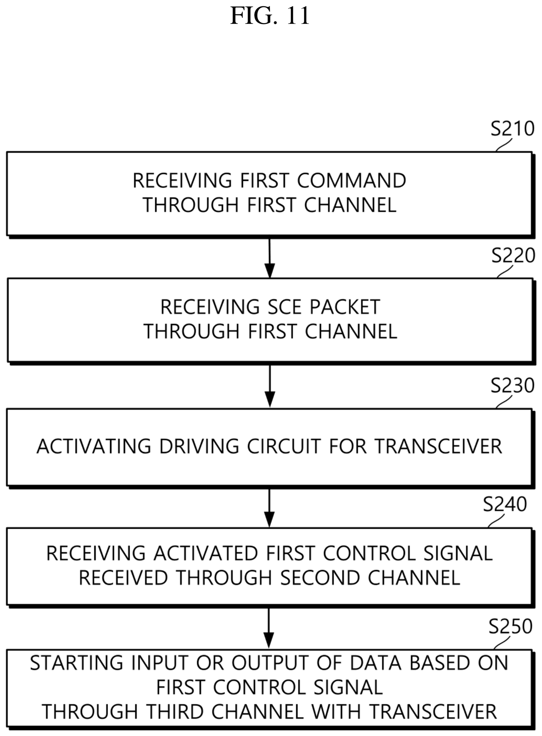

FIG. 11 is a flowchart illustrating a method of operating the memory device according to an embodiment of the disclosure. The operation method described with reference to FIG. 11 may be performed in the memory device 120 of FIG. 1. Descriptions identical or similar to the embodiments described with reference to FIGS. 9 and 10 will be omitted.

The operation method described with reference to FIG. 11 may be performed in the memory device 120 that receives the command address signal through the first channel, receives the first control signal through the second channel, and receives or transmits the data signal through the third channel.

In operation S210, the memory device 120 may receive the first command through the first channel. The first command may be a command that directs data input to or data output from the first memory die.

In operation S220, the memory device 120 may receive the first select chip enable (SCE) packet through the first channel. The first select chip enable (SCE) packet may include the chip address of the first memory die.

In operation S230, in response to receiving the first select chip enable (SCE) packet, the first memory die of the memory device 120 may activate at least one first driving circuit that drives the transceiver for the data signal transmission of the first memory die. For example, the first memory die may turn on the driving circuit that provides at least one of the driving voltage, the bias voltage, the bias current, the reference voltage, and the reference current to the transceiver for the data signal transmission of the first memory die. The first driving circuit may include at least one of the regulator, the biasing circuit, and the power gating circuit.

In operation S240, the first memory die of the memory device 120 may receive the activated first control signal through the second channel. For example, the first memory die may detect the first transition in which the first control signal transitions to the activated state.

In operation S250, the first memory die of the memory device 120 may start transmitting and receiving the first data through the third channel in response to the activated first control signal corresponding to the first transition of the first control signal.

In operation S250, the second memory die of the memory device 120, which does not correspond to the first select chip enable (SCE) packet, may perform the non-target on-die termination. For example, the second memory die may change the impedance level of the on-die termination circuit based on the first transition of the first control signal.

According to an embodiment, the first memory die corresponding to the first select chip enable (SCE) packet may also enable the target on-die termination. According to another embodiment, either the transmission circuit or the reception circuit of the first memory die may be terminated.

Before or after operation S250, the second memory die of the memory device 120 may receive the second command. The second command may be the command that directs the input of the second data to the second memory die or the output of the second data from the second memory die.

After receiving the second command, the second memory die may receive the second select chip enable (SCE) packet through the first channel and may activate at least one second driving circuit that drives the transceiver for the data signal transmission of the second memory die.

After operation S250, the first memory die may terminate or stop the transmission and reception of the first data based on the deactivated first control signal, which corresponds to the second transition of the first control signal. Subsequently, the second memory die may start the transmission and reception of the second data based on the reactivated first control signal, which corresponds to a third transition of the first control signal.

The first memory die and the second memory die may change the impedance level of the on-die termination circuit based on the second transition and the third transition of the first control signal.

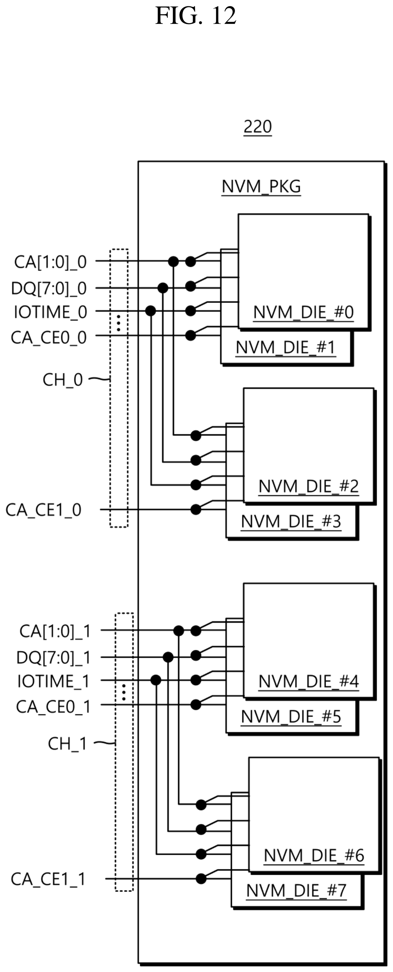

FIG. 12 is a block diagram illustrating the non-volatile memory device 220 according to an embodiment of the disclosure. The storage device may include at least one non-volatile memory device 220.

FIG. 12 illustrates an embodiment where the memory device 220 is an octa die package (ODP) memory device including eight non-volatile memory dies. However, the memory device is not limited to the ODP, and the number of memory dies in the package is not limited thereto, such as a single die package (SDP)), a double die package (DDP), a hexa die package (HDP), or the like.

FIG. 12 illustrates an embodiment where the eight non-volatile memory dies of the memory device 220 communicate with an external device via two channels, CH_0 and CH_1. However, the memory device does not limit the number of channels.

Referring to FIG. 12, the first non-volatile memory dies NVM_DIE_#0 to NVM_DIE_#3 may communicate with the external device via a first channel CH_0, and the second non-volatile memory dies NVM_DIE_#4 to NVM_DIE_#7 may communicate with the external device via a second channel CH_2.

The first channel CH_0 may include a command address signal channel CA[1:0]_0, a data signal channel DQ[7:0]_0, a first control signal channel IOTIME_0, and two command address chip enable signal channels CA_CE0_0 and CA_CE1_0. The second channel CH_1 may include a command address signal channel CA[1:0]_1, a data signal channel DQ[7:0]_1, a first control signal channel IOTIME_1, and two command address chip enable signal channels CA_CE0_1 and CA_CE1_1. For example, the first channel CH_0 and the second channel CH_1 may also include other signal channels. For example, the first channel CH_0 and the second channel CH_1 may include signal channels for NAND flash interfacing defined by JEDEC, such as a data strobe signal channel, a read enable signal channel, a command address clock signal channel, and so on.

The memory device 220 may receive the first control signal through the first control signal channels IOTIME_0 and IOTIME_1 that are respectively included in the first channel CH_0 and the second channel CH_1.

Among the first non-volatile memory dies NVM_DIE_#0 to NVM_DIE_#3, the memory die selected by the chip address of the chip enable packet, which is received via the command address signal channel CA[1:0]_0, may enable the transceiver for the data signal transmission. The memory die may transmit or receive data via the data signal channel DQ[7:0]_0 based on the first control signal received through the first control signal channel IOTIME_0.

Among the second non-volatile memory dies NVM_DIE_#4 to NVM_DIE_#7, the memory die selected by the chip address of the chip enable packet received via the command address signal channel CA[1:0]_1 may enable the transceiver for data signal transmission. The memory die may transmit or receive data via the data signal channel DQ[7:0]_1 based on the first control signal received through the first control signal channel IOTIME_1.

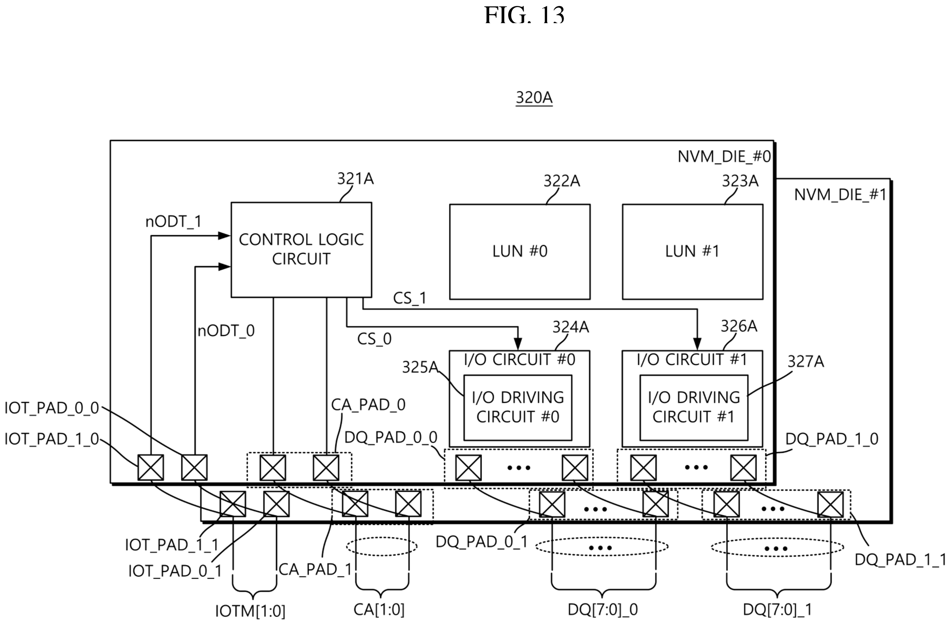

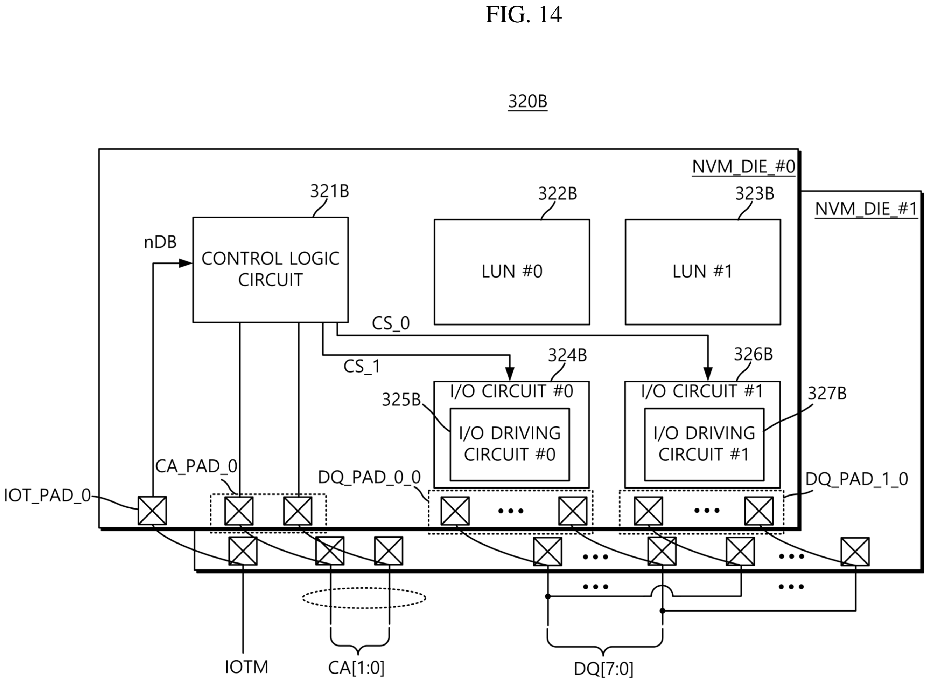

FIGS. 13 and 14 are block diagrams illustrating configurations of non-volatile memory devices 320A and 320B according to embodiments of the disclosure. FIGS. 13 and 14 illustrate memory devices 320A and 320B that include two memory dies as examples, however, the memory devices may include at least two memory dies.

Embodiments in which each memory die of the memory devices 320A and 320B includes a plurality of logical unit numbers (LUNs) are described with reference to FIGS. 13 and 14. Descriptions identical or similar to those described with reference to FIGS. 1 to 12 will be omitted. The configuration of a second memory die NVM_DIE_#1 may be the same as or similar to the configuration of a first memory die NVM_DIE_#0.

Referring to FIG. 13, the first memory die NVM_DIE_#0 of the memory device 320A may include a plurality of LUNs 322A and 323A, corresponding to LUN #0 and LUN #1, respectively.

The first memory die NVM_DIE_#0 may receive a command address signal through a first channel CA[1:0] connected to command address pads CA_PAD_0 and may transmit and receive a data signal through two second channels, DQ[7:0]_0 and DQ[7:0]_1 connected to data pads DQ_PAD_0_0 and DQ_PAD_0_1. The first memory die NVM_DIE_#0 may receive a first control signal through two third channels IOTM[1:0] that are electrically connected to first control pads IOT_PAD_0_0 and IOT_PAD_1_0.

Command address pads CA_PAD_1 of the second memory die NVM_DIE_#1 may be electrically connected to the command address pads CA_PAD_0 of the first memory die NVM_DIE_#0, and thus, they may share the first channel CA[1:0]. The data pads DQ_PAD_0_1 and DQ_PAD_1_1 of the second memory die NVM_DIE_#1 may be electrically connected to the data pads DQ_PAD_0_0 and DQ_PAD_1_0 of the first memory die NVM_DIE_#0, and thus, they may share the two second channels DQ[7:0]_0 and DQ[7:0]_1. The first control pad IOT_PAD_1 of the second memory die NVM_DIE_#1 may be electrically connected to the first control pad IOT_PAD_0 of the first memory die NVM_DIE_#0, and thus, they may share the third channel IOTM.

Data read from and data to be programmed to the first LUN 322A of the first memory die NVM_DIE_#0 and a first LUN of the second memory die NVM_DIE_#1 may be transmitted and received via the second channel DQ[7:0]_0. Data read from and data to be programmed to the second LUN 323A of the first memory die NVM_DIE_#0 and a second LUN of the second memory die NVM_DIE_#1 may be transmitted and received via the second channel DQ[7:0]_1.

Each of the LUNs of the memory die may program the received data or may transmit the read data through corresponding I/O circuits. Each of the LUNs of the memory die may transmit and receive the data signals through a corresponding data signal channel. Thus, the data of each of the LUNs of the memory die may be transmitted and received in parallel through different data signal channels.

For example, the data read from and the data to be programmed to the first LUN 322A of the first memory die NVM_DIE_#0 may be transmitted and received via a first I/O circuit 324A and the second channel DQ[7:0]_0 based on a first control signal IOTM[0]. The data read from and the data to be programmed to the second LUN 323A of the first memory die NVM_DIE_#0 may be transmitted and received via a second I/O circuit 326A and the second channel DQ[7:0]_1 based on a first control signal IOTM[1].

When the chip enable packet is received, control logic circuits of the memory dies NVM_DIE_#0 and NVM_DIE_#1 may enable the transceiver for the data signal transmission of the I/O circuit corresponding to the LUN specified by the received chip enable packet. Thus, the driving circuit of the transceiver for the data signal transmission of the I/O circuit corresponding to the specified LUN may be activated.

For example, when the chip enable packet including the LUN address of the first LUN 322A is received, a first control logic circuit 321A of the first memory die NVM_DIE_#0 may transmit an activated second control signal CS_0 to a driving circuit 325A that drives the transceiver for the data signal transmission of the first I/O circuit 324A corresponding to the first LUN 322A. The activated driving circuit 325A may provide at least one of the driving voltage, the bias voltage, the bias current, the reference voltage, and the reference current to the transceiver for the data signal transmission of the first I/O circuit 324A, and the transceiver for the data signal transmission of the first I/O circuit 324A may be enabled. For example, when the chip enable packet including the LUN address of the second LUN 323A is received, the first control logic circuit 321A of the first memory die NVM_DIE_#0 may transmit an activated second control signal CS_1 to a driving circuit 327A of the transceiver for the data signal transmission of the second I/O circuit 326A corresponding to the second LUN 323A.

In some time periods, all transceivers for the data signal transmission may be enabled in all of the I/O circuits of the same memory die.

For example, during a period in which the data read from the first LUN 322A of the first memory die NVM_DIE_#0 is being output through the data signal channel DQ[7:0]_0, the first memory die NVM_DIE_#0 may receive the chip enable packet specifying the second LUN 323A. For example, the transceiver for the data signal transmission of the second I/O circuit 326A corresponding to the second LUN 323A may be enabled along with the output of the data read from the first LUN 322A through the data signal channel DQ[7:0]_0.

When receiving internal first control signals nODT_0 and nODT_1 via the third channel IOTM after receiving the chip enable packet, the control logic circuits of the memory dies NVM_DIE_#0 and NVM_DIE_#1 may transmit and receive the data of the LUN specified by the chip enable packet via a corresponding second channel among the second channels DQ[7:0]_0 and DQ[7:0]_1 in response to the internal first control signals nODT_0 and nODT_1. Since the transceivers for the data signal transmission of the I/O circuits of the memory dies NVM_DIE_#0 and NVM_DIE_#1 are in a pre-enabled state in response to the chip enable packet, the transceivers may transmit and receive the data signals within a short time in response to the internal first control signals nODT_0 and nODT_1.

Referring to FIG. 14, the first memory die NVM_DIE_#0 of the memory device 320B may include a plurality of LUNs LUN #0 and LUN #1 (322B and 323B). The configuration of the second memory die NVM_DIE_#1 may be the same as or similar to the configuration of the first memory die NVM_DIE_#0.

Different from the embodiment described with reference to FIG. 13, the memory dies of the memory device 320B according to the embodiment illustrated in FIG. 14 may transmit and receive data signals via a single data signal channel DQ[7:0] based on a internal first control signal nODT.

Each of the LUNs of the memory die may program the received data or may transmit the read data via the corresponding I/O circuits 324B and 326B. The LUNs of the memory die may transmit and receive the data signals through the same data signal channel.

Similar to the embodiment of FIG. 13, all the transceivers for the data signal transmission of each of the memory dies of the memory device 320B according to the embodiment of FIG. 14 may be enabled in all the I/O circuits 324B and 326B during certain time periods.

Since the I/O circuits of the memory dies NVM_DIE_#0 and NVM_DIE_#1 are in the pre-enabled state in response to the chip enable packet, the I/O circuits of the memory dies NVM_DIE_#0 and NVM_DIE_#1 may transmit and receive the data signals within a short time in response to the internal first control signal nODT.

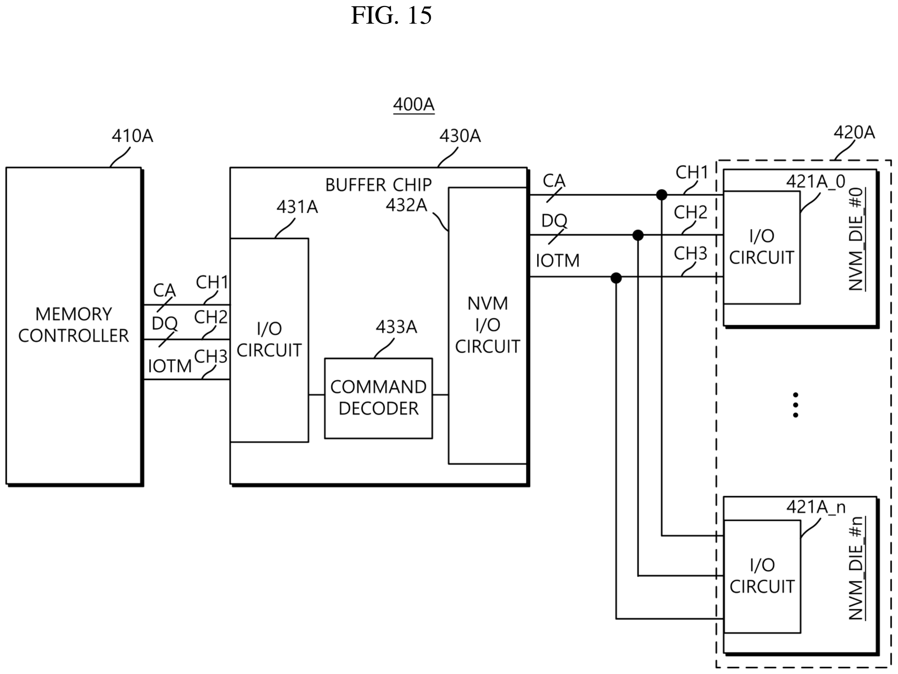

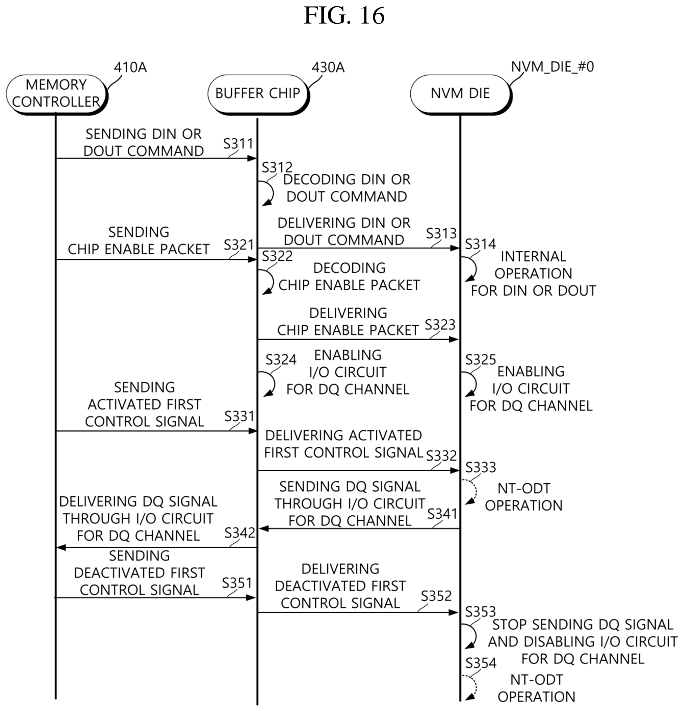

FIG. 15 is a block diagram illustrating a storage device 400A including a buffer chip 430A according to an embodiment of the disclosure. FIG. 16 is a flowchart illustrating a method of operating the storage device 400A including the buffer chip 430A of FIG. 15. FIG. 15 illustrates a single buffer chip 430A and a single non-volatile memory device 420A connected to the buffer chip 430A. However, the storage device 400A may include a plurality of buffer chips. Each of the buffer chips may be connected to at least one non-volatile memory device. The buffer chips may have the same or a similar configuration to the buffer chip 430A of FIG. 15.

A structure in which each memory die of the storage device 400A communicates with a memory controller 410A via the buffer chip 430A will be described with reference to FIGS. 15 and 16. Descriptions identical or similar to those described with reference to FIGS. 1 to 14 will be omitted.

Referring to FIG. 15, the storage device 400A may include the memory controller 410A, the memory device 420A, and the buffer chip 430A.

The memory controller 410A may generate a command address signal CA, a data signal DQ, and a first control signal IOTM, and may transmit the generated command address signal CA, data signal DQ, and first control signal IOTM to the buffer chip 430A via a first channel CH1, a second channel CH2, and a third channel CH3, respectively, which are positioned between the memory controller 410A and the buffer chip 430A. The buffer chip 430A may receive the command address signal CA, the data signal DQ, and the first control signal IOTM via a first I/O circuit 431A corresponding to the memory controller 410A.

The buffer chip 430A may transmit the command address signal CA, the data signal DQ, and the first control signal IOTM to the memory device 420A via a first I/O circuit 432A corresponding to the memory device 420A. The buffer chip 430A may transmit the received command address signal CA, the data signal DQ, and the first control signal IOTM to the memory device 420A via the first channel CH1, the second channel CH2, and the third channel CH3, respectively, which are positioned between the buffer chip 430A and the memory device 420A.

The memory device 420A may include a plurality of memory dies NVM_DIE_#0 through NVM_DIE_#n. One of the memory dies of the memory device 420A may receive the command address signal CA, the data signal DQ, and the first control signal IOTM via the first channel CH1, the second channel CH2, and the third channel CH3, respectively. The first channel CH1, the second channel CH2, and the third channel CH3 are positioned between the buffer chip 430A and the memory device 420A. The memory dies NVM_DIE_#0 through NVM_DIE_#n may share the first channel CH1, the second channel CH2, and the third channel CH3 between the buffer chip 430A and the memory device 420A. The first channel CH1, the second channel CH2, and the third channel CH3 between the buffer chip 430A and the memory device 420A may connect an I/O circuit of each of the memory dies NVM_DIE_#0 through NVM_DIE_#n to the first I/O circuit 432A of the buffer chip 430A. The I/O circuit of each of the memory dies NVM_DIE_#0 through NVM_DIE_#n may be electrically connected to a pad connected to the first I/O circuit 432A.

The memory dies NVM_DIE_#0 through NVM_DIE_#n may include second I/O circuits 421A_0 through 421A_n, respectively.

The first I/O circuits 431A and 432A of the buffer chip 430A and the second I/O circuits 421A_0 through 421A_n of the memory device 420A may be similar to the I/O circuit 129 of the memory die NVM_DIE_#0 described with reference to FIG. 2.

In an embodiment, the first I/O circuits 431A and 432A and the second I/O circuits 421A_0 through 421A_n may include a transceiver and a driving circuit. The driving circuit may include a circuit that provides at least one of a driving voltage, a bias voltage, a bias current, a reference voltage, and a reference current to the transceiver. The transceiver for data signal transmission of the first I/O circuits 431A and 432A and the second I/O circuits 421A_0 through 421A_n may be enabled by the driving circuit. The driving circuit may include a regulator, a biasing circuit, and a power gating circuit. For example, the driving circuit may include a reference providing circuit that provides a reference voltage and/or a reference current for a signal comparison operation to at least one of a transmission circuit and a reception circuit of the transceiver.

The first I/O circuit 432A of the buffer chip 430A may be enabled based on a chip enable packet received from the memory controller 410A.

In an embodiment, based on the chip enable packet received from the memory controller 410A, the transceiver that transmits the data signal DQ in the first I/O circuits 431A and 432A of the buffer chip 430A may be enabled. A command decoder 433A of the buffer chip 430A may decode commands received from the memory controller 410A, and when the decoded commands are the chip enable packet, the command decoder 433A may activate the driving circuits of the first I/O circuits 431A and 432A that enable the transceiver transmitting the data signal DQ.

Further, each of the second I/O circuits 421A_0 through 421A_n of the memory dies NVM_DIE_#0 through NVM_DIE_#n of the memory device 420A may be enabled based on the chip enable packet transmitted from the buffer chip 430A. The transceiver of the second I/O circuit of the memory die corresponding to the chip enable packet among the memory dies may be enabled based on the chip enable packet.

In an embodiment, based on the chip enable packet received from the buffer chip 430A, a transceiver that transmits the data signal DQ in a second I/O circuit corresponding to the chip enable packet among the second I/O circuits 421A_0 through 421A_n may be enabled. The control logic circuit of the memory die corresponding to the chip enable packet may activate the driving circuits that enable the transceiver transmitting the data signal DQ in the second I/O circuit.

For example, the memory controller 410A may transmit a read command and a data output command to read data from the first memory die NVM_DIE_#0 to the buffer chip 430A via the first channel CH1 between the memory controller 410A and the buffer chip 430A,.and the buffer chip 430A may transmit the read command and the data output command to the first memory die NVM_DIE_#0 via the first channel CH1 between the buffer chip 430A and the memory device 420A. Then, the buffer chip 430A may receive the chip enable packet including the chip address of the first memory die NVM_DIE_#0 and may transmit the chip enable packet to the first memory die NVM_DIE_#0 of the memory device 420A. In response to the chip enable packet, the buffer chip 430A may enable the transceiver transmitting the data signal DQ in the first I/O circuits 431A and 432A, and the first memory die NVM_DIE_#0 may enable the transceiver transmitting the data signal DQ in the second I/O circuit 421A_0.

The memory die among the memory dies NVM_DIE_#0 through NVM_DIE_#n, which corresponds to the chip enable packet, may start the input or output of the data signal through the enabled transceiver and the third channel CH3, which is between the buffer chip 430A and the memory device 420A, based on the first control signal IOTM transmitted by the buffer chip 430A.

Referring to FIGS. 15 and 16, the method of operating the storage device 400A including the buffer chip 430A according to the embodiment of FIG. 15 is described. The embodiment described with reference to FIG. 16 is explained on the premise of the data input or output between the first memory die NVM_DIE_#0 and the buffer chip 430A. In some embodiments, a read command or a program command may be transmitted from the memory controller 410A to the first memory die NVM_DIE_#0 via the buffer chip 430A prior to the data input command DIN and the data output command DOUT.

In operation S311, the memory controller 410A may transmit the data input command DIN or the data output command DOUT to the buffer chip 430A via the first channel CH1.

In operation S312, the command decoder 433A of the buffer chip 430A may decode the data input command DIN or the data output command DOUT and may transmit the decoded data input command DIN or the decoded data output command DOUT to the first memory die NVM_DIE_#0 via the first channel CH1.

In operation S314, the first memory die NVM_DIE_#0 may perform an internal operation corresponding to the data input command DIN or the data output command DOUT. For example, sensed data may be stored in an input/output register in response to the data output command DOUT.

In operation S321, the memory controller 410A may transmit the chip enable packet to the buffer chip 430A via the first channel CH1.

In operation S322, the buffer chip 430A may decode the chip enable packet, and in operation S323, the chip enable packet may be transmitted to the first memory die NVM_DIE_#0 based on a chip address included in the chip enable packet.

In operation S324, the buffer chip 430A may enable the transceiver transmitting the data signal DQ in the first I/O circuits 431A and 432A in response to receiving the chip enable packet. The buffer chip 430A may transmit an activated second control signal to the driving circuit that drives the transceiver transmitting the data signal DQ.

In operation S325, the first memory die NVM_DIE_#0 may enable the transceiver transmitting the data signal DQ in the second I/O circuit 421A_0 in response to receiving the chip enable packet. For example, all the memory dies NVM_DIE_#0 through NVM_DIE_#n sharing the channels may receive the chip enable packet. Each of the memory dies may verify the chip address of the chip enable packet and may identify its own target die status based on the chip address. The target die corresponding to the chip enable packet may enable the transceiver that transmits the data signal DQ.

In operation S331, the memory controller 410A may transmit an activated first control signal IOTM to the buffer chip 430A via the third channel CH3. In operation S332, the buffer chip 430A may transmit the activated first control signal IOTM to the memory dies NVM_DIE_#0 through NVM_DIE_#n that share the channels.

In operation S333, each of the memory dies NVM_DIE_#0 through NVM_DIE_#n may perform non-target on-die termination when the memory die is a non-target die. According to an embodiment, the target die may perform target on-die termination.

In operation S341, the first memory die NVM_DIE_#0 may transmit the data signal DQ to the buffer chip 430A via the transceiver of the second I/O circuit 421A_0 and the second channel CH2 in response to the activated first control signal IOTM.

In an embodiment, during a period in which the first memory die NVM_DIE_#0 is transmitting the data signal DQ to the buffer chip 430A via the second channel CH2, at least one of the first memory die NVM_DIE_#0 and the second memory die NVM_DIE_#1 may transmit the command address signal CA to the buffer chip 430A through the first channel CH1.

In operation S342, the buffer chip 430A may transmit the data signal DQ, which is received via the transceiver and the second channel CH2, to the memory controller 410A.

In operation S351, the memory controller 410A may transmit a deactivated first control signal IOTM to the buffer chip 430A.

In operation S352, the buffer chip 430A may transmit the deactivated first control signal IOTM to the memory dies NVM_DIE_#0 through NVM_DIE_#n that share the channels.

In operation S353, the first memory die NVM_DIE_#0 may stop the input or output of the data signal through the second channel CH2 in response to the deactivated first control signal IOTM. The first memory die NVM_DIE_#0 may disable the transceiver for data signal transmission of the second I/O circuit 421A_0 in response to the deactivated first control signal IOTM. The buffer chip 430A may disable the transceiver for data signal transmission of the first I/O circuits 431A and 432A.

In operation S354, each of the memory dies NVM_DIE_#0 through NVM_DIE_#n may stop performing the non-target on-die termination when the memory die is a non-target die. According to an embodiment, the target die may stop performing the target on-die termination.

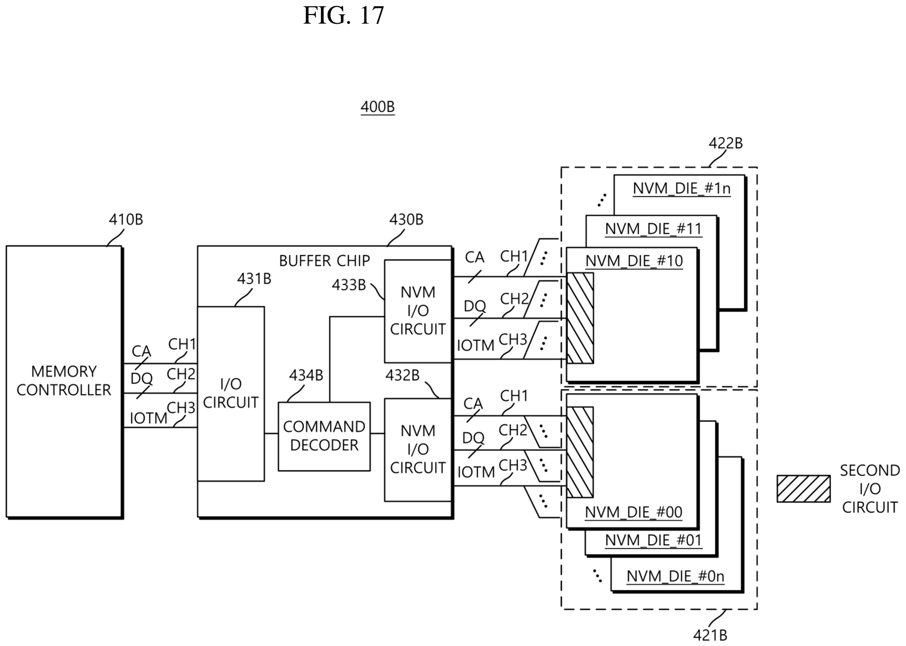

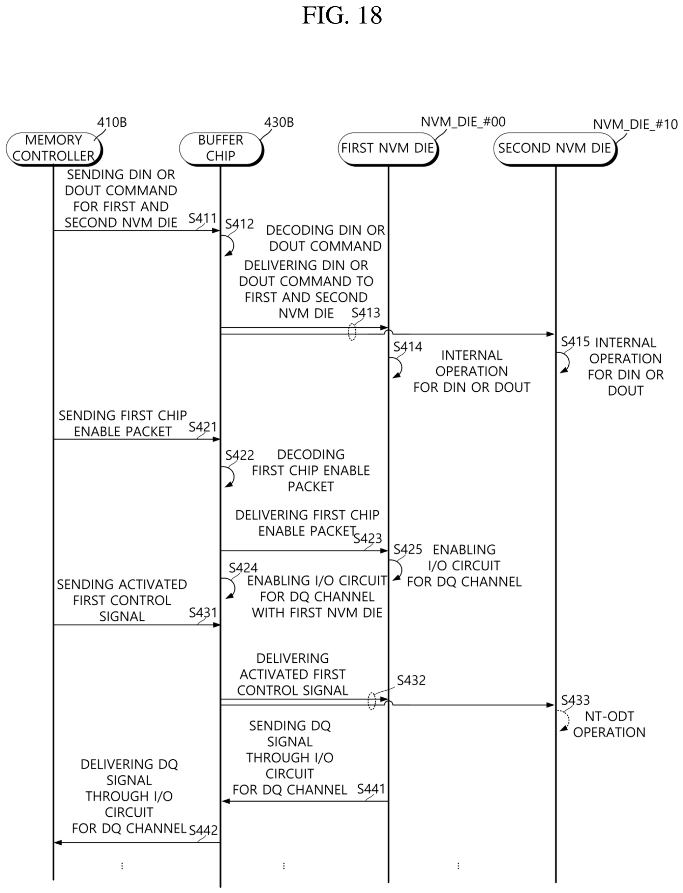

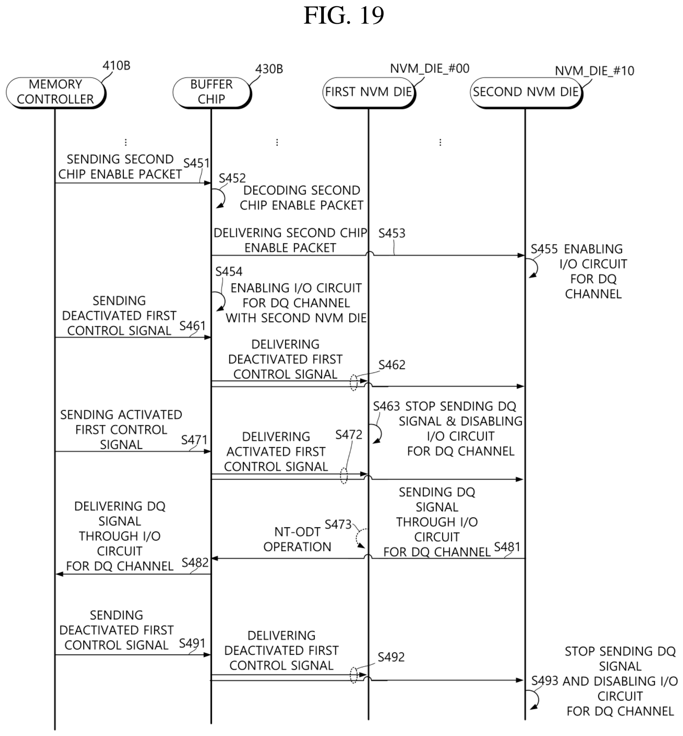

FIG. 17 is a block diagram illustrating a storage device 400B including a buffer chip 430B according to an embodiment of the disclosure. FIGS. 18 and 19 are flowcharts illustrating a method of operating the storage device 400B including the buffer chip 430B of FIG. 17.

FIG. 17 illustrates one buffer chip 430B and two groups of non-volatile memory dies NVM_DIE_#00 through NVM_DIE_#0n and NVM_DIE_#10 through NVM_DIE_#1n connected to the buffer chip 430B. However, unlike FIG. 17, the storage device 400B may include a plurality of buffer chips. Each of the buffer chips may be connected to a plurality of non-volatile memory die groups. The buffer chips may have a configuration identical or similar to that of the buffer chip 430B of FIG. 17.

The storage device 400B in which each memory die communicates with a memory controller 410B through the buffer chip 430B will be described with reference to FIGS. 17 to 19. Descriptions identical or similar to the embodiments with reference to FIGS. 15 and 16 will be omitted, and the following description will focus on differences therebetween.

Referring to FIG. 17, the storage device 400B may include the memory controller 410B, the buffer chip 430B, and two groups of non-volatile memory dies NVM_DIE_#00 through NVM_DIE_#0n and NVM_DIE_#10 through NVM_DIE_#1n.

Each of the two groups of non-volatile memory dies NVM_DIE_#00 through NVM_DIE_#0n and NVM_DIE_#10 through NVM_DIE_#1n may be implemented as separate packaged memory devices or may be implemented as a single packaged memory device. The embodiment described with reference to FIG. 17 is described in a case that each of the two groups of non-volatile memory dies NVM_DIE_#00 through NVM_DIE_#0n and NVM_DIE_#10 through NVM_DIE_#1n is implemented as separate packaged memory devices, however, the disclosure is not limited thereto.

Different from the buffer chip 430A of FIG. 15, the buffer chip 430B of FIG. 17 may include three first I/O circuits 431B, 432B, and 433B.

For example, the first I/O circuit 431B may communicate with the memory controller 410B, the first I/O circuit 432B may communicate with a first memory device 421B, and the first I/O circuit 433B may communicate with a second memory device 422B. An I/O circuit of the first memory device 421B may be electrically connected to a pad connected to the first I/O circuit 432B, and an I/O circuit of the second memory device 422B may be electrically connected to a pad connected to the first I/O circuit 433B.

The buffer chip 430B may transmit a command address signal CA, a data signal DQ, and a first control signal IOTM, which are received from the memory controller 410B, to the first memory device 421B or the second memory device 422B via one of internal paths and one of the first I/O circuits 432B and 433B.

In an embodiment, a command decoder 434B of the buffer chip 430B may decode the command address signal received from the memory controller 410B, and based on the decoded address, the command decoder 434B of the buffer chip 430B may transmit the command address signal to the first memory device 421B or the second memory device 422B via one of the internal paths and one of the first I/O circuits 432B and 433B.

As an example, the command decoder 434B may decode a received chip enable packet and, based on the chip address included in the chip enable packet, may select one of the internal paths and one of the first I/O circuits 432B and 433B.

In an embodiment, the command decoder 434B of the buffer chip 430B may enable a transceiver that communicates with a memory device corresponding to the chip address based on the chip enable packet. For example, among transceivers that communicate with the memory device corresponding to the chip address, the transceiver that transmits and receives the data signal DQ may be enabled. Among the transceivers communicating with the memory device that does not correspond to the chip address, the transceiver that transmits and receives the data signal DQ may not be enabled. Further, the command decoder 434B may enable the transceiver that transmits and receives the data signal DQ to and from the memory controller 410B based on the chip enable packet.

Hereinafter, a method of operating the storage device 400B including the buffer chip 430B of FIG. 17 will be described with reference to FIGS. 17 to 19. The embodiment described with reference to FIGS. 18 and 19 is described on the premise of the data input or output between the buffer chip 430B and the first memory die NVM_DIE_#00 among the memory dies NVM_DIE_#00, NVM_DIE_#01,..., NVM_DIE_#0n of the first memory device 421B and between the buffer chip 430B and the second memory die NVM_DIE_#10 among the memory dies NVM_DIE_#10, NVM_DIE_#1 1,..., NVM_DIE_#1n of the second memory device 422B. Further, in some embodiments, a read command or a program command may be transmitted from the memory controller 410B to the first memory dies NVM_DIE_#00 and NVM_DIE_#10 through the buffer chip 430B before the data input command DIN and the data output command DOUT for the data input or output. Descriptions identical or similar to the embodiment with reference to FIGS. 15 and 16 will be omitted, and the following description will focus on differences therebetween.

Referring to FIG. 18, in operation S411, the memory controller 410B may transmit a data input command DIN or a data output command DOUT for the first memory die NVM_DIE_#00 or the second memory die NVM_DIE_#10 to the buffer chip 430B via a first channel CH1.

In operation S412, the command decoder 434B of the buffer chip 430B may decode the data input command DIN or the data output command DOUT, and in operation S413, the command decoder 434B may transmit the data input command DIN or the data output command DOUT to the first memory die NVM_DIE_#00 or the second memory die NVM_DIE_#10 via the first channel CH1.

In each operations S414 and S415, the first memory die NVM_DIE_#00 or the second memory die NVM_DIE_#10 may perform an internal operation corresponding to the data input command DIN or the data output command DOUT.

In operation S421, the memory controller 410B may transmit a first chip enable packet to the buffer chip 430B through the first channel CH1. A first chip enable packet is described on the premise that the first chip enable packet includes the chip address of the first memory die NVM_DIE_#00.

In operation S422, the buffer chip 430B may decode the first chip enable packet, and in operation S423, the buffer chip 430B may activate a path connected to the first memory die NVM_DIE_#00 among the internal paths to transmit the first chip enable packet to the first memory die NVM_DIE_#00 based on the chip address included in the first chip enable packet.

In operation S424, the buffer chip 430B may enable the transceiver that transmits the data signal DQ in the first I/O circuits 431B and 432B in response to receiving the first chip enable packet.

In operation S425, the first memory die NVM_DIE_#00 may enable the transceiver that transmits the data signal DQ in a second I/O circuit in response to receiving the first chip enable packet.

In operation S431, the memory controller 410B may transmit an activated first control signal IOTM to the buffer chip 430B through a third channel CH3, and in operation S432, the buffer chip 430B may transmit the activated first control signal IOTM to the memory devices 421B and 422B.

In operation S433, the second memory die NVM_DIE_#10 may perform non-target on-die termination. According to an embodiment, the first memory die NVM_DIE_#00, which is the target die, may perform target on-die termination.

In operation S441, the first memory die NVM_DIE_#00 may transmit the data signal DQ to the buffer chip 430B through the transceiver of the second I/O circuit and a second channel CH2 in response to the activated first control signal IOTM.

In operation S442, the buffer chip 430B may transmit the received data signal DQ to the memory controller 410B through the transceiver of the first I/O circuit 431B and the second channel CH2.

Referring to FIG. 19, in operation S451, the memory controller 410B may transmit a second chip enable packet to the buffer chip 430B through the first channel CH1. A second chip enable packet is described on the premise that the second chip enable packet includes the chip address of the second memory die NVM_DIE_#10.

In operation S452, the buffer chip 430B may decode the second chip enable packet. In operation S453, the buffer chip 430B may transmit the second chip enable packet to the second memory die NVM_DIE_#10.

In operation S454, the buffer chip 430B may enable the transceiver that transmits the data signal DQ in the first I/O circuits 431B and 433B in response to receiving the second chip enable packet.

In operation S455, the second memory die NVM_DIE_#10 may enable the transceiver that transmits the data signal DQ in the second I/O circuit in response to receiving the second chip enable packet.

In an embodiment, a first time period, during which the second I/O circuit of the first memory die NVM_DIE_#00 is enabled based on the first chip enable packet, may overlap (e.g., partially overlap) a second time period, during which the second I/O circuit of the second memory die NVM_DIE_#10 is enabled based on the second chip enable packet. For example, a third time period, during which the first I/O circuit 432B is enabled based on the first chip enable packet, may overlap (e.g., partially overlap) a fourth time period during which the first I/O circuit 433B is enabled based on the second chip enable packet.

In operation S461, the memory controller 410B may transmit a deactivated first control signal IOTM to the buffer chip 430B.

In operation S462, the buffer chip 430B may transmit the deactivated first control signal IOTM to the memory devices 421B and 422B.

In operation S463, the first memory die NVM_DIE_#00 may stop the input or output of the data signal through the second channel CH2 in response to the deactivated first control signal IOTM.

In operation S471, the memory controller 410B may re-transmit the activated first control signal IOTM to the buffer chip 430B through the third channel CH3, and in operation S472, the buffer chip 430B may transmit the activated first control signal IOTM to the memory devices 421B and 422B.

In operation S473, the first memory die NVM_DIE_#00 may perform the non-target on-die termination. According to an embodiment, the second memory die NVM_DIE_#10, which is the target die, may perform the target on-die termination.

In operation S481, the second memory die NVM_DIE_#10 may transmit the data signal DQ to the buffer chip 430B through the transceiver of the second I/O circuit and the second channel CH2 in response to the activated first control signal IOTM.

In operation S482, the buffer chip 430B may transmit the received data signal DQ to the memory controller 410B through the transceiver of the first I/O circuit 431B and the second channel CH2.

In operation S491, the memory controller 410B may transmit the deactivated first control signal IOTM to the buffer chip 430B.

In operation S492, the buffer chip 430B may transmit the deactivated first control signal IOTM to the memory devices 421B and 422B.

In operation S493, the second memory die NVM_DIE_#10 may stop the input or output of the data signal through the second channel CH2 in response to the deactivated first control signal IOTM.

Embodiments of the disclosure will be described.

The storage device may include the memory controller configured to generate the command address signal, the data signal, and the first control signal, the buffer chip configured to receive the command address signal, the data signal, and the first control signal from the memory controller through different channels, respectively, and to transmit the command address signal, the data signal, and the first control signal to at least one of the non-volatile memory dies through different channels, and the non-volatile memory dies each including the I/O circuit configured to receive the command address signal through the first channel, the data signal through the second channel, and the first control signal through the third channel from the buffer chip. Among the non-volatile memory dies, the first non-volatile memory die may transmit the activated second control signal to at least one driving circuit that enables the transceiver for data transmission of the I/O circuit in response to receiving the first select chip enable packet received through the first channel, and may transmit or receive the first data through the second channel based on the first select chip enable packet and the first control signal received through the third channel.

The first non-volatile memory die may be the non-volatile memory die corresponding to the LUN address of the first select chip enable packet.

The first non-volatile memory die may identify whether the first non-volatile memory die is the target die based on the LUN address of the first select chip enable packet.

The first non-volatile memory die may start and/or end the transmission and/or reception of the first data with the buffer chip and may start and/or terminate (or end) the on-die termination based on the first control signal.

The buffer chip may include a first buffer chip I/O circuit communicating with the memory controller and a second buffer chip I/O circuit communicating with the non-volatile memory dies, and may enable the transceiver for data transmission in each of the first buffer chip I/O circuit and the second buffer chip I/O circuit in response to the first select chip enable packet.

The non-volatile memory dies may include the first non-volatile memory die and the second non-volatile memory die, and the second buffer chip I/O circuit may include a third buffer chip I/O circuit communicating with the first non-volatile memory die and a fourth buffer chip I/O circuit communicating with the second non-volatile memory die. The buffer chip may enable the third buffer chip I/O circuit which communicates with the first non-volatile memory die corresponding to the first select chip enable packet.

The buffer chip may transmit the activated second control signal to at least one driving circuit that enables the third buffer chip I/O circuit.

The at least one driving circuit may include at least one of the regulator, the power gating circuit, and the switch circuit, and the regulator, the power gating circuit, and the switch circuit may be electrically connected to at least one of the input/output buffer and the signal transmission circuit of the third buffer chip I/O circuit.

In response to receiving the second select chip enable packet received through the first channel, the second non-volatile memory die may transmit an activated third control signal to at least one driving circuit that drives the I/O circuit, and may transmit or receive the first data through the second channel based on the second select chip enable packet and the first control signal received through the third channel.

The buffer chip may transmit the first control signal to the first non-volatile memory die and the second non-volatile memory die.

The non-volatile memory dies may include the first non-volatile memory die and the second non-volatile memory die. The I/O circuit of the first non-volatile memory die may be electrically connected to the first pad of the buffer chip, and the I/O circuit of the second non-volatile memory die may be electrically connected to the second pad of the buffer chip. The first pad and the second pad may be the same as each other or may be different from each other.

The buffer chip may further include the command decoder that decodes the command address signal. The buffer chip may be configured to determine the first non-volatile memory die among the non-volatile memory devices based on the decoding result of the command address signal.

One of the first non-volatile memory die and the second non-volatile memory die may transmit the command and the address through the first channel during transmission or reception of the first data to or from the first non-volatile memory die through the second channel.

The buffer chip may include the first I/O circuit receiving the command address signal, the data signal, and the first control signal from the memory controller through different channels, at least one second I/O circuit transmitting the command address signal, the data signal, and the first control signal to at least one of the non-volatile memory dies through different channels, and the command decoder decoding the command address signal. The command decoder may be configured to transmit the activated second control signal to the driving circuit that enables the transceiver for data transmission of the at least one second I/O circuit in response to receiving the first select chip enable packet from the memory controller.

The second I/O circuit may include a third I/O circuit communicating with the first non-volatile memory die among the non-volatile memory dies and a fourth I/O circuit communicating with the second non-volatile memory die among the non-volatile memory dies. The command decoder may enable the third I/O circuit which communicates with the first non-volatile memory die corresponding to the first select chip enable packet.

The command decoder may disable the third I/O circuit based on the first control signal.

The command decoder may enable the fourth I/O circuit, which communicates with the second non-volatile memory die, in response to the second select chip enable packet received from the memory controller.

The first time period during which the third I/O circuit communicating with the first non-volatile memory die is enabled in response to the first select chip enable packet and the second time period, during which the fourth I/O circuit communicating with the second non-volatile memory die is enabled in response to the second select chip enable packet, may overlap each other during the third time period.

The method of operating the buffer chip that connects the non-volatile memory dies to the memory controller includes allowing the I/O circuit corresponding to the memory controller communicating with the memory controller to receive the first command that directs the input of the first data to the first non-volatile memory die among the non-volatile memory dies or the output of the first data from the first non-volatile memory die through the first channel, allowing the I/O circuit corresponding to the memory controller to receive the first select chip enable packet including the LUN address of the first non-volatile memory die through the first channel, and allowing the command decoder to turn on at least one first driving circuit that enables the transceiver for data transmission of the first I/O circuit communicating with the first non-volatile memory die in response to receiving the first select chip enable packet

The method of operating the buffer chip may further include allowing the I/O circuit corresponding to the memory controller to transmit the first control signal received through the second channel to the first non-volatile memory die, allowing the first I/O circuit to receive the first data from the first non-volatile memory die or transmit the first data to the first non-volatile memory die through the third channel, and allowing the command decoder to disable the first I/O circuit based on the first control signal.

While the disclosure has been described with reference to certain embodiments thereof, it will be apparent to those of ordinary skill in the art that various changes and modifications may be made thereto without departing from the scope of the disclosure as set forth in the following claims.

## Claims

1. A storage device (100) comprising:
a memory device (120) comprising:
a first channel (CH1), a second channel (CH2), and a third channel (CH3), each of the first channel (CH1), the second channel (CH2), and the third channel (CH3) comprising at least one pin,
a plurality of memory blocks, and
a transceiver (129_5) configured to transmit and receive data through the second channel (CH2); and
a memory controller (110) configured to:
transmit a command and an address to the memory device (120) through the first channel (CH1),
transmit and receive the data to and from the memory device (120) through the second channel (CH2), and
transmit a first control signal (IOTM) to the memory device (120) through the third channel (CH3),
wherein the memory device (120) is configured to:
transmit a second control signal in an activated state to at least one driving circuit configured to drive the transceiver (129_5) in response to receiving a select chip enable packet through the first channel (CH1), and
transmit or receive first data through the second channel (CH2) based on the select chip enable packet and the first control signal (IOTM).

2. The storage device (100) of claim 1, wherein the memory device (120) is configured to:
determine whether a memory die is a target die based on a logical unit number, LUN, address comprised in the select chip enable packet,
start or end transmission or reception of the first data based on whether the memory die is the target die and the first control signal (IOTM), and
start or end on-die termination.

3. The storage device (100) of claim 1 or 2, wherein the memory controller (110) is configured to transmit the first control signal (IOTM) in an activated state or transmit the first control signal (IOTM) having a pulse, after transmitting the select chip enable packet comprising a logical unit number, LUN, address associated with the first data.

4. The storage device (100) of any preceding claim, wherein the memory device (120) comprises:
a memory cell array (121) configured to store the first data;
a page buffer circuit (122) configured to store the first data sensed from the memory cell array;
the transceiver (129_5) configured to transmit the first data to the memory controller (110) through the second channel (CH2); and
a control logic circuit (123) configured to decode the command,
wherein the control logic circuit (123) is configured to transmit the second control signal in the activated state to at least one of a regulator (129_1), a power gating circuit (129_3), or a switch circuit, in response to receiving the select chip enable packet, and
wherein the regulator (129_1), the power gating circuit, and the switch circuit are electrically connected to the transceiver (129_5).

5. The storage device (100) of claim 4, wherein the power gating circuit (129_3) is configured to connect the transceiver (129_5) to one of a driving voltage node and a ground node, and stop power gating based on the second control signal in the activated state,
wherein the regulator (129_1) is configured to apply a driving voltage obtained by voltage-dropping an external supply voltage based on the second control signal in the activated state, and
wherein the switch circuit is configured to connect the transceiver (129_5) and the second channel (CH2) based on the second control signal in the activated state.

6. The storage device (100) of claim 4 or 5, wherein the control logic circuit (123) is configured to:
start transmitting and receiving the first data in response to the first control signal (IOTM) in the activated state,
terminate the transmission and reception of the first data in response to the first control signal (IOTM) in a deactivated state, and
transmit the second control signal in a deactivated state to the at least one driving circuit.

7. The storage device (100) of claim 4 or 5, wherein the control logic circuit (123) is configured to:
start the transmission and reception of the first data in response to a first pulse of the first control signal (IOTM),
terminate the transmission and reception of the first data in response to a second pulse of the first control signal (IOTM), and
transmit the second control signal in a deactivated state to the at least one driving circuit,
wherein the control logic circuit is configured to distinguish the first pulse from the second pulse based on whether a memory die is the target die according to a LUN address comprised in the select chip enable packet, and
wherein the first pulse and the second pulse have a same pulse width.

8. The storage device (100) of any preceding claim, wherein the memory device (320A, 320B) comprises a first memory die (NVM_DIE_#0) and a second memory die (NVM_DIE_#1),
wherein the first memory die (NVM_DIE_#0) and the second memory die (NVM_DIE_#1) share the first channel (CH1), the second channel (CH2), and the third channel (CH3),
wherein the first memory die (NVM_DIE_#0) is configured to turn on at least one of a first regulator, a first power gating circuit, and a first switch circuit based on a first select chip enable packet and to turn off the at least one of the first regulator, the first power gating circuit, and the first switch circuit based on the second control signal in a deactivated state,
wherein the second memory die (NVM_DIE_#1) is configured to turn on at least one of a second regulator, a second power gating circuit, and a second switch circuit based on a second select chip enable packet and to turn off the at least one of the second regulator, the second power gating circuit, and the second switch circuit based on the second control signal in the deactivated state,
wherein the first select chip enable packet comprises a first address indicating the first memory die (NVM_DIE_#0),
wherein the second select chip enable packet comprises a second address indicating the second memory die (NVM_DIE_#1),
wherein the first regulator, the first power gating circuit, and the first switch circuit are electrically connected to a transceiver of the first memory die (NVM_DIE_#0), and
wherein the second regulator, the second power gating circuit, and the second switch circuit are electrically connected to a transceiver of the second memory die (NVM_DIE_#1).

9. The storage device (100) of claim 8, wherein a first time period, during which the at least one of the first regulator, the first power gating circuit, and the first switch circuit is activated based on the first select chip enable packet, overlaps a second time period, during which the at least one of the second regulator, the second power gating circuit, and the second switch circuit is activated based on the second select chip enable packet.

10. The storage device (100) of any preceding claim, wherein the memory device (120) is configured to change an impedance level of an on-die termination circuit based on the first control signal (IOTM).

11. The storage device (100) of any preceding claim, wherein the memory controller (110) is configured to transmit the select chip enable packet comprising a chip address through the first channel (CH1) during a first time period in which second data is transmitted through the second channel (CH2).

12. A method of operating a non-volatile memory device (120) comprising a plurality of memory dies sharing a first channel (CH1), a second channel (CH2), and a third channel (CH3), the method comprising:
receiving (S210) a first command (IOTM) to direct input of first data to a first memory die or output of the first data from the first memory die through the first channel (CH1);
receiving (S220) a first select chip enable packet to select the first memory die through the first channel (CH1);
controlling the first memory die to turn on at least one first driving circuit that drives a transceiver of the first memory die in response to receiving the first select chip enable packet;
sensing, by the first memory die, a first transition of a first control signal (IOTM) received through the third channel (CH3); and
controlling the transceiver of the first memory die to transmit or receive the first data through the second channel (CH2) based on the first transition.

13. The method of claim 12, further comprising:
controlling at least one of the first memory die (NVM_DIE_#0) and a second memory die (NVM_DIE_#1) to change an impedance level of an on-die termination circuit based on the first transition.

14. The method of claim 12, further comprising:
receiving a second command to direct an input of second data to a second memory die (NVM_DIE_#1) or an output of the second data from the second memory die (NVM_DIE_#1) through the first channel (CH1);
receiving a second select chip enable packet to select the second memory die (NVM_DIE_#1) through the first channel (CH1);
controlling the second memory die (NVM_DIE_#1) to turn on at least one second driving circuit that drives a transceiver of the second memory die (NVM_DIE_#1) in response to receiving the second select chip enable packet;
sensing, by the first memory die (NVM_DIE_#0), a second transition of the first control signal (IOTM) using the third channel (CH3); and
controlling the transceiver of the first memory die (NVM_DIE_#0) to terminate or stop transmitting or receiving the first data through the second channel (CH2) based on the second transition;
sensing, by the second memory die (NVM_DIE_#1), a third transition of the first control signal (IOTM) through the third channel (CH3); and
controlling the transceiver of the second memory die (NVM_DIE_#1) to transmit or receive the second data through the second channel (CH2) based on the third transition.

15. The method of claim 14, further comprising:
controlling at least one of the first memory die (NVM_DIE_#0) and the second memory die (NVM_DIE_#1) to change an impedance level of an on-die termination circuit based on the second transition.
